(19) **Europäisches Patentamt / European Patent Office / Office européen des brevets**

(11) **EP 2 890 016 A1**

(12) **EUROPEAN PATENT APPLICATION**

(43) Date of publication:
**01.07.2015 Bulletin 2015/27**

(51) Int Cl.:
*H03M 13/11* *(2006.01)*   *H03M 13/29* *(2006.01)*
*H03M 13/00* *(2006.01)*

(21) Application number: **13306892.4**

(22) Date of filing: **30.12.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**92100 Boulogne-Billancourt (FR)**

(72) Inventors:
• **Mahdaviani, Kaveh**
  **Toronto M5S3G4 (CA)**
• **Schmalen, Laurent**
  **70435 Stuttgart (DE)**

(74) Representative: **2SPL Patentanwälte PartG mbB**
**Postfach 15 17 23**
**80050 München (DE)**

(54) **Ldpc encoder and decoder**

(57)     Embodiments relate to an LDPC encoder (1000) for encoding an input signal (1002). The LDPC encoder (1000) comprises a first encoder entity (1010) to provide, in accordance with a first LDPC encoding rule, a first encoded output signal (1012) based on the input signal (1002); a second encoder entity (1020) to provide, in accordance with a second LDPC encoding rule, a second encoded output signal (1022) based on the input signal (1002); wherein a first bipartite graph (500-1) corresponding to the first LDPC encoding rule is coupled to a second bipartite graph (500-2) corresponding to the second LDPC encoding rule via one or more shared nodes among the first and the second bipartite graph (500-1; 500-2).

Fig. 10

**Description**

Embodiments of the present invention relate to communication systems and, more particularly, to communication systems employing Low-Density Parity-Check (LDPC) codes.

Background

This section introduces aspects that may be helpful in facilitating a better understanding of the inventions. Accordingly, the statements of this section are to be read in this light and are not to be understood as admissions about what is in the prior art or what is not in the prior art.

A Low-Density Parity-Check (LDPC) code is a linear error correcting code for transmitting a message over a noisy transmission channel. It may be constructed using a sparse bipartite graph whose vertices can be divided into two disjoint independent sets $U$ and $V$ such that every edge connects a vertex in $U$ to one in $V$. Examples of bipartite graphs used for LPDC codes are the so-called Tanner graph or graph prototypes (protographs). In coding theory, bipartite graphs may be used to construct longer codes from smaller ones. Both LPDC encoders and LPDC decoders may employ these graphs extensively.

A possible application of LDPC codes is in optical or wireless communication systems. As the LDPC codes used in optical communications are mainly high-rate LDPC codes with rates higher than 0.8 (overhead smaller than 25%), these LDPC codes are usually based on parity check matrices of size $M$ (rows) $\times N$ (columns), with $M << N.$

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the Maximum A-Posteriori (MAP) thresholds of the underlying ensemble. Analogous to LDPC block codes, LDPC convolutional codes may be defined by sparse parity-check matrices, which allow them to be decoded using iterative message-passing algorithms.

Summary

Some simplifications may be made in the following summary, which is intended to highlight and introduce some aspects of the various exemplary embodiments, but such simplifications are not intended to limit the scope of the inventions. Detailed descriptions of a preferred exemplary embodiment adequate to allow those of ordinary skill in the art to make and use the inventive concepts will follow in later sections.

According to a first aspect, embodiments provide an LDPC encoder for encoding an input signal. The LDPC encoder includes a first encoder entity which is operable to provide, in accordance with a first LDPC encoding rule, a first encoded output signal based on the input signal. Further, the LDPC encoder includes a second encoder entity which is operable to provide, in accordance with a second LDPC encoding rule, a second encoded output signal based on the input signal. Note that the input signal may be partitioned into a first and a second part that may be separately encoded by both LDPC encoders. Thereby a first bipartite graph corresponding to the first LDPC encoding rule is coupled to a second bipartite graph corresponding to the second LDPC encoding rule via one or more shared nodes among the first and the second bipartite graph.

In embodiments the shared or coupled nodes may be variable nodes (code-bit nodes) and/or check nodes (constraint nodes) of the first and/or the second bipartite graph. The first and the second bipartite graphs may be Tanner graphs or protographs in some embodiments. In one or more embodiments the first and/or the second LDPC encoding rule may correspond to a Spatially Coupled LDPC (SC-LDPC) or LDPC convolutional code, respectively.

The LDPC encoder is configured to perform a corresponding method. Hence, according to a further aspect, embodiments provide a method for encoding an input signal. The method includes encoding the input signal in accordance with a first LDPC encoding rule to obtain a first encoded output signal, and encoding the input signal in accordance with a second LDPC encoding rule to obtain a second encoded output signal. A first bipartite graph corresponding to the first LDPC encoding rule is coupled to a second bipartite graph corresponding to the second LDPC encoding rule via one or more shared nodes among the first and the second bipartite graph.

According to yet a further aspect, embodiments provide an LDPC decoder for decoding an encoded input signal. The LDPC decoder includes a first decoder entity which is operable to provide, in accordance with a first LDPC decoding rule, a first decoded output signal based the encoded input signal. The LDPC decoder also includes a second decoder entity operable to provide, in accordance with a second LDPC decoding rule, a second decoded output signal based the encoded input signal. A first bipartite graph corresponding to the first LDPC decoding rule is coupled to a second bipartite graph corresponding to the second LDPC decoding rule via one or more shared nodes among the first and the second bipartite graph.

The LDPC decoder is configured to perform a corresponding method. Hence, according to a further aspect, embodiments provide a method for decoding an encoded input signal. The methods includes decoding the encoded input signal in accordance with a first LDPC decoding rule to obtain a first decoded output signal, and decoding the encoded input signal in accordance with a second LDPC decoding rule to obtain a second decoded output signal. Thereby a first bipartite graph corresponding to the first LDPC decoding rule is coupled to a second bipartite graph corresponding to the second LDPC decoding rule via one or more shared nodes among the first and the second bipartite graph.

Some embodiments comprise digital circuitry installed within the encoder and/or decoder for performing the respective methods. Such a digital control circuitry, e.g., a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method, when the computer program is executed on a computer or a programmable hardware device.

Embodiments may provide robust codes that can, for example, be applied efficiently in channels which have a time-varying channel quality. Embodiments may provide a wider range in the degrees of freedom for code design by introducing more design parameters. Moreover, embodiments may achieve better probability of errors compared to conventional LDPC codes, in particular compared to conventional Spatially Coupled LDPC (SC-LDPC) codes.

Brief description of the Figures

Some embodiments of apparatuses and/or methods will be described in the following by way of example only, and with reference to the accompanying figures, in which

Fig. 1    illustrates block diagram of a conventional row-layered LDPC decoding algorithm;

Fig. 2    shows four phases of windowed decoding of spatially coupled LDPC convolutional codes;

Fig. 3    illustrates an example of a copy-and-permute operation for a protograph-based LDPC code using a protomatrix **B**;

Fig. 4    shows a visualization of a parity check matrix **H** obtained by lifting of the lifting matrix **A** obtained from the protograph shown in Fig. 3;

Fig. 5    shows a protograph-based code design for Spatially-Coupled Codes and its corresponding protograph matrix **B**;

Fig. 6    illustrates a mapping function $X = \varphi(b_1, b_2, b_3)$ for an 8-APSK constellation;

Fig. 7    shows a transmitter and receiver of multilevel coding with multi-stage decoding;

Fig. 8    shows a decoding pipeline of a multi-stage decoder;

Fig. 9    shows a transmitter and receiver of a BICM scheme with optional iterative decoding;

Fig. 10    illustrates an example encoder for two laterally coupled chains of spatially coupled codes with syndrome former memory $\mu$=1;

Fig. 11    illustrates an encoder for two laterally uncoupled chains of spatially coupled codes with syndrome former memory $\mu$=1;

Fig. 12    illustrates lateral coupling on protograph level with extra coupling protograph nodes, wherein the extra coupling nodes can be either interpreted as variable nodes or as check nodes;

Fig. 13    shows an equivalent protomatrix to the protograph chain depicted in Fig. 12, where the coupling nodes are interpreted as check nodes;

Fig. 14    shows an equivalent protograph to the one in Fig. 12 with shared variable nodes;

Fig. 15    illustrates an equivalent protomatrix to the protograph chains in Fig 14, where the shared nodes are accounted for in chain 1;

Fig. 16    illustrates the protograph of Fig. 14 where the laterally coupled variable nodes are alternatingly assigned to chain 1 and chain 2;

Fig. 17    illustrates an application of the proposed coding scheme to higher order modulation schemes;

Fig. 18    shows lateral coupling on intermediate protograph level which is obtained from a smaller protograph by a first lifting with first lifting factor P=5;

Fig. 19    shows lateral coupling on intermediate protograph level which is obtained from a smaller protograph by a first lifting with first lifting factor P=5, alternating assignment of coupled nodes to either chain 1 or chain 2 to achieve a regular distribution of the code bits;

Fig. 20    shows windowed decoding of laterally uncoupled spatially coupled codes with three chains;

Fig. 21    illustrates an example of a windowed decoding of three laterally coupled chains where chain 1 coupled with chain 2, chain 2 coupled with chains 1 and 3, and chain 3 couples with chain 2 only;

Fig. 22    illustrates an example of an extra check node processor unit for laterally coupled diversity nodes;

Fig. 23    illustrates an example of a check node processing operation with accesses to non-shared chain memory and accesses to shared memory where $C_s$ engines have inputs connected to the shared memory (partial lifting if $C_s < S$) and $S-C_s$ engines only have connections to the chain memory;

Fig. 24    shows a graph where each circle represents a variable node position which contains $M$ variable nodes, each square represents a check node position consisting of $M$ check nodes, The edges between positions denote the posibility of connections between nodes of the adjacent positions;

Fig. 25    shows a structure of one instance of laterally connected SC-LDPC codes wherein the structure comprises 3 chains with lateral connectivity implemented in a non-tailbiting sequential order, shared variable node positions represent that the variable nodes of these positions might be shared with some predefined probability;

Fig. 26    illustrates a comparison between the BER for the basic SC-LDPC design and a proposed design;

Fig. 27    shows decoding thresholds of the laterally coupled SC codes (two different degree distributions, C=4 chains) versus single-chain codes; and

Fig. 28    shows an estimated erasure probability (by density evaluation) for different coding realizations of different rates for an erasure channel with Gaussian distributed erasure probability (mean 0.5, variance 0.001).

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

For a better understanding of embodiments, a short introduction to LDPC codes and some related decoding algorithms will be provided in the following.

An LDPC code may be defined by a sparse parity-check matrix $\mathbf{H}$ of dimension $M \times N$, where $N$ is the LDPC code word length (e.g., in bits) of the LDPC code and $M$ denotes the number of parity bits or symbols. The rows of a parity check matrix are parity checks on the code words of a code. That is, they show how linear combinations of certain digits of each code word equal zero. Usually, the number of information symbols equals $N$-$M$ (but can be larger, depending on the rank of the parity-check matrix $\mathbf{H}$). The design rate of the code amounts to $r = (N$-$M)/N$. The overhead of the code is defined as OH $= 1/r$-$1 = M/(N$-$M)$. Sparse means that the number of 1s in $\mathbf{H}$ is small compared to the number of zero entries. Practical LDPC codes usually have a fraction of "1s" that is below 1 % by several orders of magnitude.

We start by introducing some notation and terminology related to LDPC codes. Each column of the parity check matrix $\mathbf{H}$ corresponds to one symbol (e.g. a bit) of a Forward Error Correction (FEC) frame or LPDC code word. As LDPC codes can also be represented in a graphical structure called Tanner graph, the columns of $\mathbf{H}$ and thus the FEC frame (LPDC code word) symbols are sometimes also referred to as variable nodes, referring to the graph-theoretic representation. Similarly, each row of $\mathbf{H}$ corresponds to a parity check equation and ideally defines a parity symbol (e.g., a parity bit), if $\mathbf{H}$ has full rank. For example, the rank can be defined as the column rank. The column rank of a matrix $\mathbf{H}$ is the maximum number of linearly independent column vectors of $\mathbf{H}$. Correspondingly, the row rank of $\mathbf{H}$ is the maximum number of linearly independent row vectors of $\mathbf{H}$. Owing to the Tanner graph representation, the rows of $\mathbf{H}$ are associated to so-called check nodes, and the columns of $\mathbf{H}$ are associated to so-called variable nodes. Further, the $M$ rows of $\mathbf{H}$ specify $M$ check node connections, and the $N$ columns of $\mathbf{H}$ specify $N$ variable node connections. Thereby, check node $i$ is connected to variable node $j$ whenever element $h_{ij}$ in $\mathbf{H}$ is different from zero. Note that the row rank and the column rank of a matrix $\mathbf{H}$ are always equal, which is a well-known result in linear algebra.

In order to describe an exemplary LDPC decoder we introduce some additional notation. First, we denote by $\mathbf{x}$ a vector of $K = N - M$ information symbols. The single elements of $\mathbf{x}$ are denoted by $x_i$, i.e., $\mathbf{x} = (x_1, x_2, ..., x_i, ..., x_K)^T$. After encoding with an exemplary LDPC encoder, an LDPC code word $\mathbf{y} = (y_1, y_2, ..., y_N)^T$ of length $N$ results. We denote by $y_i$ the single elements of the code word $\mathbf{y}$. The LDPC code is said to be systematic if the information vector $\mathbf{x}$ is included in the code word, e.g., if (after possible rearrangement) $\mathbf{y} = (x_1, ..., x_K, p_1, ... p_M)^T$, with $\mathbf{p} = (p_1, ..., p_M)^T$ denoting the vector of $M$ parity symbols. Furthermore, let the set $\mathcal{N}(m)$ denote the positions of the 1s in the $m$-th row of $\mathbf{H}$, i.e., $\mathcal{N}(m) = \{i: H_{m,i} = 1\}$. A binary vector $\mathbf{y}$ is a code word of the LDPC code defined by $\mathbf{H}$, if $\mathbf{Hy} = \mathbf{0}$, with the additions defined over the binary field (addition modulo-2, or XOR, respectively), for example. The set of code words is thus defined to be the null space of $\mathbf{H}$. This signifies that the product of each row of $\mathbf{H}$ and $\mathbf{y}$ is zero, or

$$\sum_{j \in \mathcal{N}(m)} y_j = 0, \quad \text{for all } m \text{ with } 1 \le m \le M .$$

Let us illustrate the concept of LDPC codes by a "toy" example. This example defines a binary parity check matrix $\mathbf{H}$ of two concatenated (4, 5) single parity check codes, separated by a $4 \times 5$ block-interleaver. The exemplary parity check matrix $\mathbf{H}$ of dimension $9 \times 25$ is given by

$$\mathbf{H} = \begin{pmatrix} 1 & 1 & 1 & 1 & & & & & & & & & & & & & & 1 & & & & & & & \\ & & & & 1 & 1 & 1 & 1 & & & & & & & & & & & 1 & & & & & & \\ & & & & & & & & 1 & 1 & 1 & 1 & & & & & & & & 1 & & & & & \\ & & & & & & & & & & & & 1 & 1 & 1 & 1 & & & & & 1 & & & & \\ 1 & & & & 1 & & & & 1 & & & & 1 & & & & & & & & 1 & & & & \\ & 1 & & & & 1 & & & & 1 & & & & 1 & & & & & & & & 1 & & & \\ & & 1 & & & & 1 & & & & 1 & & & & 1 & & & & & & & & 1 & & \\ & & & 1 & & & & 1 & & & & 1 & & & & 1 & & & & & & & & 1 & \\ & & & & & & & & & & & & & & & & 1 & 1 & 1 & 1 & & & & & 1 \end{pmatrix}.$$

Note that for simplicity reasons only the 1s are illustrated in the parity check matrix **H** above. Thus, $M = 9$, $N = 25$, and the code has an overhead of 56% (given by $M/(N-M)$) or a rate of $r = 0.64$, equivalently. We have $\mathcal{N}$ (1) = {1; 2; 3; 4; 17}, $\mathcal{N}$ (2) = {5; 6; 7; 8; 18}, $\mathcal{N}$ (3) = {9; 10; 11; 12; 19}, $\mathcal{N}$ (4) = {13; 14; 15; 16; 20}, $\mathcal{N}$ (5) = {1; 5; 9; 13; 21}, $\mathcal{N}$ (6) = {2; 6; 10; 14; 22}, $\mathcal{N}$ (7) = {3; 7; 11; 15; 23}, $\mathcal{N}$ (8) = {4; 8; 12; 16; 24}, $\mathcal{N}$ (9) = {17; 18; 19; 20; 25}. This means for instance that we have (using the first row of **H**) $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit.

One common decoding algorithm for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we focus on the latter.

In the context of coherent detection, we can usually assume an equivalent Additive White Gaussian Noise (AWGN) channel model for the transmission channel. This assumption is justified by the central limit theorem which applies due to the extensive use of filtering in inner Digital Signal Processing (DSP) stages of a transmitter and/or receiver. If we denote by $y_i$ ($i = 1, ..., N$) the single bits of an LDPC code word **y** as defined above, then the received values at the input of an LDPC decoder amount to $z_i = y_i + n_i$, with $n_i$ ($i = 1, ..., N$) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$L(z_i) = \log\left( \frac{p(z_i \mid y_i = 0)}{p(z_i \mid y_i = 1)} \right) \tag{1}$$

with $p(z_i \mid y_i = k) = \exp\left(- (z_i - (1 - 2k))^2 /(2\sigma^2) \right)/ \sqrt{2\pi\sigma^2}$ denoting the probability density function (pdf) of the received sample $z_i$ under AWGN assumption conditioned on the transmitted bit $y_i$ and with bipolar signaling ($y_i=0 \rightarrow +1$, $y_i=1 \rightarrow -1$). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

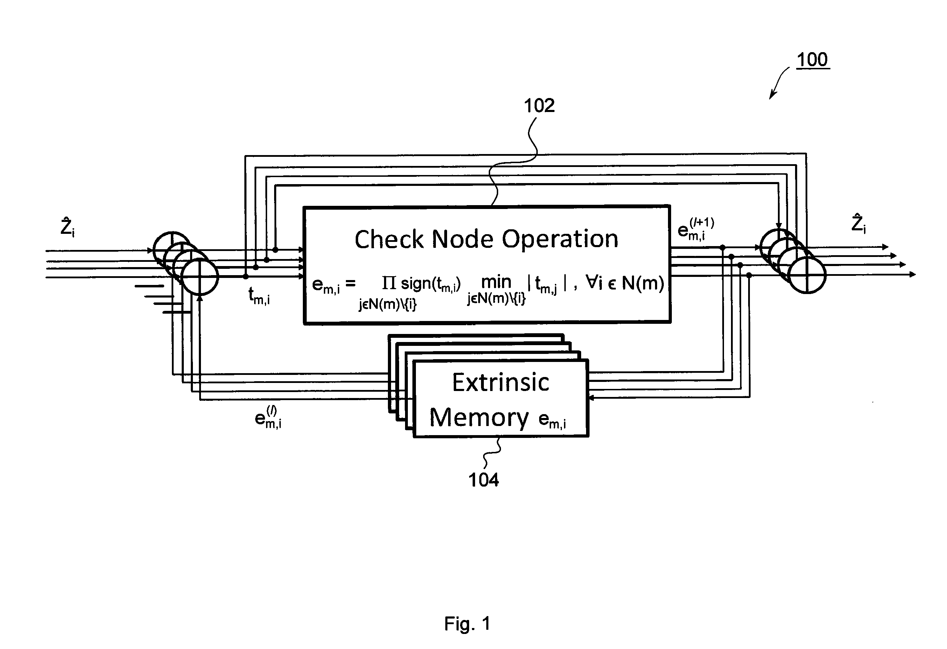

Turning now to **Fig. 1**, we describe a conventional row-layered LDPC decoding algorithm. Here, a LDPC decoder 100 continuously updates the received LLR values with the goal to compute LLRs that approximate the Maximum A-Posteriori (MAP) values. The received vector of LLRs **z** is therefore copied to a memory $\hat{\mathbf{z}}$ of size $N$, which is continuously updated. This memory maybe referred to as LLR memory or a-posteriori memory in later sections of this specification. The decoding operation in the row-layered decoder 100 comprises three acts, where a) the first act prepares the input data, b) the second act performs the computation of new extrinsic data and c) the final act updates the LLR memory. The row-layered LDPC decoder 100 may carry out the three steps sequentially for each row of the parity check matrix **H**. After all rows have been considered, a single decoding iteration has been carried out. The LDPC decoder 100 usually carries out several iterations, where the number depends on the available resources.

In the following, we describe the aforementioned three acts for a single row $m$ of **H**. The first step a) comprises

computing card( $\mathcal{N}(m)$ ) = $d_c$ (card = cardinality) temporary values $t_{m,i}$, with

$$t_{m,i} = \hat{z}_i - e_{m,i}^{(l)} \qquad \text{for all } i \in \mathcal{N}(m) \qquad (2)$$

for all non-zero entries (indexed by $i$) of the $m$'th row of **H**. The superscript$^{(l)}$ denotes the iteration counter, i.e., the operations are carried out in the $l$-th iteration of the row-layered LDPC decoding procedure. The value $e_{m,i}$ is the (stored) extrinsic memory for row $m$ and variable $\hat{z}_i$. At the beginning of the decoding of a single LDPC frame (code word), all $e_{m,i}$ may be initialized by zero (i.e., $e_{m,i}^{(1)} = 0$) and then continuously updated. Note that in total only $\Sigma_m$ card( $\mathcal{N}(m)$ ) memory locations may be used for storing the $e_{m,i}$. If the code is check-regular, $\Sigma_m$ card( $\mathcal{N}(m)$ ) = $M \cdot d_c$. In the second step, the extrinsic memory 104 for the subsequent iteration ($l$+1) may be updated using the $t_{m,i}$ according to

$$
\begin{aligned}
e_{m,i}^{(l+1)} &= 2 \cdot \tanh^{-1}\left( \prod_{j \in \mathcal{N}(m)\backslash\{i\}} \tanh\left(\frac{t_{m,j}}{2}\right) \right) \qquad \text{for all } i \in \mathcal{N}(m) \\
&= \left[ \prod_{j \in \mathcal{N}(m)\backslash\{i\}} \text{sign}\left(t_{m,j}\right) \right] \cdot \phi\left( \sum_{j \in \mathcal{N}(m)\backslash\{i\}} \phi\left(|t_{m,j}|\right) \right), \quad \text{with } \phi(\tau) = -\log\left( \tanh\left(\frac{\tau}{2}\right) \right) = \log\left( \frac{e^\tau + 1}{e^\tau - 1} \right)
\end{aligned} \qquad (3)
$$

where the log-domain expression of the Sum-Product Algorithm (SPA) according to equation (3) may be more suitable for practical implementations, as the multiplication is replaced by an addition and instead of two functions $\tanh(\cdot)/\tanh^{-1}(\cdot)$, only a single function $\phi(\cdot)$ needs to be implemented (or approximated by a look-up table). The product (or the sum) of equation (3) may be carried out over all entries in $\mathcal{N}(m)$ except the one under consideration $i$. This is indicated by the notation $\mathcal{N}(m)/\{i\}$. For instance, in the above example, where $\mathcal{N}(5) = \{1; 5; 9; 13; 21\}$, $e_{5,13}^{(l+1)}$ may be computed corresponding to

$$
\begin{aligned}
e_{5,13}^{(l+1)} &= 2 \cdot \tanh^{-1}\left( \prod_{j \in \mathcal{N}(5)\backslash\{13\}} \tanh\left(\frac{t_{m,j}}{2}\right) \right) = 2 \cdot \tanh^{-1}\left( \prod_{j \in \{1;5;9;21\}} \tanh\left(\frac{t_{m,j}}{2}\right) \right) \\
&= 2 \cdot \tanh^{-1}\left( \tanh\left(\frac{t_{5,1}}{2}\right) \tanh\left(\frac{t_{5,5}}{2}\right) \tanh\left(\frac{t_{5,9}}{2}\right) \tanh\left(\frac{t_{5,21}}{2}\right) \right).
\end{aligned} \qquad (4)
$$

The derivation of equation (4) for the extrinsic update is beyond the scope of this specification. Usually, if high LDPC decoder throughputs shall be achieved, the computation of $e_{m,i}$ can be further simplified. An often employed simplification of the SPA log-domain equation (3), which we will consider in the following, is the so-called min-sum approximation or min-sum algorithm which leads to

$$e_{m,i}^{(l+1)} = \left[ \prod_{j \in \mathcal{N}(m)\backslash\{i\}} \text{sign}(t_{k,j}) \right] \min_{j \in \mathcal{N}(m)\backslash\{i\}} |t_{m,j}| \qquad \text{for all } i \in \mathcal{N}(m). \qquad (5)$$

As the second act b) computes the output of the parity check node $m$ of the check node in the graphical representation of LDPC codes, it is frequently denoted by check node operation 102. Hence, equation (5) may be denoted as min-sum check-node update operation having reduced complexity vis-à-vis the SPA check-node update operations of equation (3).

In the next decoding act c), the LLR memory may be updated corresponding to

$$\hat{z}_i = t_{m,i} + e_{m,i}^{(l+1)} \qquad \text{for all } i \in \mathcal{N}(m) \qquad (6)$$

and the LDPC decoder 100 may continue with decoding row $m+1$ or, if $m = M$, restarts at $m = 1$ (next iteration, $l + 1$).

Fig. 1 shows the simplified block diagram 100 of the min-sum check-node update operation for computing $e_{m,i}^{(l+1)}$ according to equation (5) for card($\mathcal{N}(m)$) = 4 (i.e., **H** contains for 1s at row $m$). As has been explained before, the check node operation 102 may be realized by equations (3) (log-domain SPA) or (5) (min-sum domain). Note that a routing network to access the different $\hat{z}_i$ (which are not necessarily stored in neighboring memory locations) is not shown in the Fig. 1.

The second step b), i.e., the check-node update, can be further simplified in actual implementations. Let $\mu_m^{[1]} = \min\limits_{j \in \mathcal{N}(m)} |t_{m,j}|$ be the first minimum of the absolute value of all involved incoming messages $t_{m,j}$ at row m and let $i_m^{[1]} = \arg\min\limits_{j \in \mathcal{N}(m)} |t_{m,j}|$ be the position (i.e., the index) of this first minimum. Let furthermore $\mu_m^{[2]} = \min\limits_{j \in \mathcal{N}(m)\setminus\{i_m^{[1]}\}} |t_{m,j}|$ be the second minimum (larger than the first minimum) of all incoming messages at row $m$. We further define $s_m = \prod\limits_{j \in \mathcal{N}(m)} \text{sign}(t_{m,j})$. The output message can then be computed corresponding to

$$e_{m,i}^{(l+1)} = s_m \cdot \text{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases}. \qquad (7)$$

Note that equation (7) is an alternative representation of the min-sum check-node update operation of equation (5). Thus, one burden for implementing the check node operation 102 for computing $e_{m,i}^{(l+1)}$ consists in finding the first and second minimum of the incoming messages together with the position of the first minimum. The memory requirements of this algorithm are $N$ memory cells for storing the (continuously updated) a-posteriori values $\hat{z}_i$. Additionally, the storing requirements of the extrinsic memory $e_{m,i}$ 104 amount to the total number of 1s in the parity check matrix **H**, however, due to the simplified implementation using the minimum approximation, the extrinsic memory 104 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm according to equation (5) is only an approximation to the full belief-propagation expression of equation (3), numerous attempts have been made to improve the performance of the min-sum algorithm, i.e., the min-sum check-node update operation. One notable improvement is the so-called offset min-sum algorithm. The check-node update rule of the offset min-sum algorithm reads

$$e_{m,i}^{(l+1)} = s_m \cdot \mathrm{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}, \qquad (8)$$

where the offset correction variable $\beta$ can either be constant and determined offline or be updated during decoding according to a predefined rule.

While in the 1960s and the following decades, most coding research focused on block coding techniques, many practical coding schemes were based upon convolutional codes. With the advent of turbo codes and the rediscovery of LDPC codes, this suddenly changed such that nowadays most new coding schemes are again block codes. The trend is, however, to return back to convolutional-like structures.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the MAP thresholds of the underlying ensemble. Thus, contrary to a common belief, introducing structure into LDPC codes leads to a class of (degenerated) realizations of LDPC codes which show superior performance under belief propagation decoding. This effect of threshold saturation by introducing structure has been analyzed for the Binary Erasure Channel (BEC) and it has been shown that spatially coupled LDPC codes can asymptotically achieve the MAP threshold of the underlying regular ensemble under belief propagation decoding. Recently, this result has been extended to more general channels and it has been shown that spatially coupled ensembles universally achieve capacity over binary-input memoryless symmetric-output channels: most codes of this ensemble are good for each channel realization of this class of channels.

For simplicity, we exemplarily consider time-independent LDPC convolutional codes, but all embodiments can be extended to time-varying LDPC convolutional codes by introducing additional time indexing. Instead of being a block code of dimension $N$ with parity-check matrix $\mathbf{H}$, a time-independent LDPC convolutional code has an infinitely extended parity-check matrix $\mathbf{H}_{conv}$, which has the following form

$$\mathbf{H}_{conv} = \begin{pmatrix} \ddots & & & & & & \\ \ddots & \mathbf{H}_0 & & & & & \\ \vdots & \mathbf{H}_1 & \mathbf{H}_0 & & & & \\ \ddots & \vdots & \mathbf{H}_1 & \mathbf{H}_0 & & & \\ & \mathbf{H}_\mu & \vdots & \mathbf{H}_1 & \ddots & & \\ & & \mathbf{H}_\mu & \vdots & \ddots & & \\ & & & \mathbf{H}_\mu & \vdots & & \\ & & & & \ddots & \end{pmatrix}_\infty .$$

Thereby the value $\mu$ is commonly called the syndrome former memory, in analogy to convolutional codes. For simplicity only, we look in the remainder of this specification at the case $\mu = 1$, leading to

$$\mathbf{H}_{conv} = \begin{pmatrix} \ddots & & & & \\ \ddots & \mathbf{H}_0 & & & \\ & \mathbf{H}_1 & \mathbf{H}_0 & & \\ & & \mathbf{H}_1 & \mathbf{H}_0 & \\ & & & \mathbf{H}_1 & \ddots \\ & & & & \ddots \end{pmatrix}_\infty .$$

Note, however, that embodiments also comprise implementations with values of $\mu$ other than 1, e.g., $\mu = 0$ (leading to an LDPC block code) or $\mu > 1$. We see that $\dim(\mathbf{H}_0) = \dim(\mathbf{H}_1) = M \times N$ has to hold. Note that in practical systems, the code is usually terminated. For optical communication systems, which may usually be implemented in a stream-like mode, it is convenient to terminate the code only at the beginning of a transmission (or at the beginning of a super-frame) and thus we may consider left-terminated codes with the parity-check matrix

$$\mathbf{H}_{conv} = \begin{pmatrix} \mathbf{H}_0 & & & & & \\ \mathbf{H}_1 & \mathbf{H}_0 & & & & \\ & \mathbf{H}_1 & \ddots & & & \\ & & \ddots & \mathbf{H}_0 & & \\ & & & \mathbf{H}_1 & \mathbf{H}_0 & \\ & & & & \mathbf{H}_1 & \ddots \\ & & & & & \ddots \end{pmatrix}_{\infty}$$

This termination has a crucial effect on the performance and is responsible for the outstanding asymptotic performance of this class of codes.

In the remainder of the description we consider the case $\mu = 1$. Embodiments can however be extended to larger values of $\mu$ in a straight forward fashion. Spatially coupled or LDPC convolutional codes may be decoded using a sliding window decoding scheme to recover the information sequences. A decoder may operate on a window of w copies of the row defining matrix $[\mathbf{H}_1\ \mathbf{H}_0]$. For faster convergence speed, the windowed decoding can be combined with the aforementioned row-decoding or layered decoding algorithm. The layered decoder continuously updates and refines the received LLR values in the decoding window with the goal to compute LLRs that approximate the MAP values.

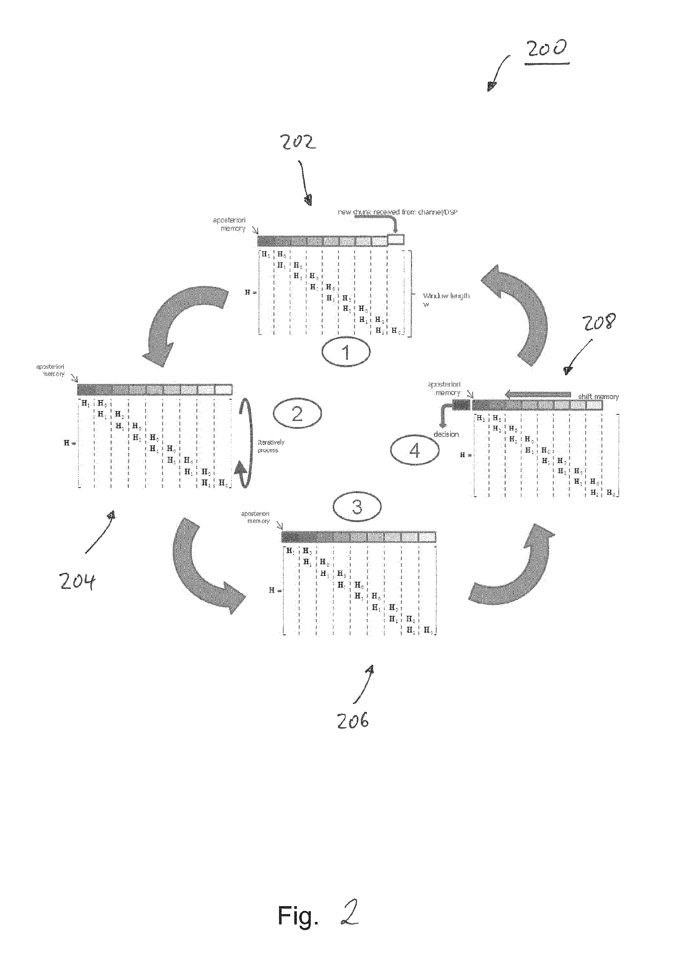

Four exemplary cycles of a windowed decoder 200 are depicted in **Fig. 2** for an example with window size $w = 8$.

The windowed decoder 200 makes use of an a-posteriori memory of size $(w+\mu)N$, with $N = \text{columns}(\mathbf{H}_0) = \text{columns}(\mathbf{H}_1)$. In a first step 202 of the illustrated cycle a new chunk (size $N$) of received LLRs at time instant $t$ is received and inserted into an appropriate position of the decoder's a-posteriori memory. In a second step 204, a predefined number of decoder iterations may be executed making use of the row defining matrix $[\mathbf{H}_1\ \mathbf{H}_0]$. Note that the row decoder algorithm can be designed for this matrix $[\mathbf{H}_1\ \mathbf{H}_0]$ and then can be reused by just accessing appropriately shifted memory locations. The different shades of grey in a third step 206 (as well as in the other steps) indicate reliabilities of different chunks of received LLRs in the a-posteriori memory. It can be observed that the reliabilities increase from right to left, i.e., the oldest values having received the highest number of updates, have the largest reliability. In a fourth step 208 of the cycle 200, the a-posteriori memory is shifted and the left-most LLR chunk is forwarded to a hard decision circuit in order to recover hypothetically transmitted symbols. After the shifting, there is now room for a new chunk that can be inserted in the first step 202 of the next cycle. Note that the windowed decoding algorithm introduces a decoding delay of $w+\mu\text{-}1$ frames, such that at time instant $t$, we can recover the information frame $\mathbf{x}'_{t-w-\mu+1}$. This is however of no issue in an optical communication system operating in a streaming fashion. Note that at the beginning an LDPC convolutional like encoder may be initialized with zeros at its second input. Thereby the second input may be dedicated to a delayed version of an encoded output signal, which may be fed back to the second encoder input. Hence, in the case of LDPC convolutional encoders the two inputs to the encoder at time instant $t$ may be an input signal $\mathbf{x}_t$ (to be encoded) as well as the delayed (encoded) output signal $\mathbf{y}_{t-1}$ (and, if $\mu > 1$, $\mathbf{y}_{t-1}, ..., \mathbf{y}_{t-\mu}$). If the transmission starts at $t = 0$, this means that we set $\mathbf{y}_{-1}=\mathbf{0}$. Accordingly, the memory of the decoder 200 may be initialized with perfect knowledge about the initial symbols being zero ($+\infty$).

Further, we consider a protograph-based construction of terminated spatially coupled (also commonly called terminated convolutional) LDPC codes. Thereby a protograph is a convenient way of describing certain sub-classes of LDPC codes. Protograph codes are constructed from a so-called $P$-cover of a relatively small graph which conveys the main properties of the code. The protograph serves as a blueprint for constructing LDPC codes of arbitrary size whose performance can be predicted by analyzing the protograph. A protograph can be any Tanner graph, typically one with a relatively small number of nodes. A protograph $G = (V, C, E)$ comprises a set of variable nodes $V$, a set of check nodes $C$, and a set of edges $E$. Each edge $e \in E$ connects a variable node $v_e \in V$ to a check *node* $c_e \in C$. Parallel edges are permitted, so the mapping $e \rightarrow (v_e, c_e) \in V \times C$ is surjective and thus not necessarily 1:1. This means that in contrast to the graph representation of the LDPC code, the protograph may contain multiple edges between variable and check nodes. The code itself is constructed by placing $P$ copies of the protograph next to each other (note that these have no interconnecting edges) and permuting the edges between the different copies of the protograph, such that the relation between the group of edges is respected.

This copy-and-permute operation for a protograph may be described by a protomatrix. An example of such a protomatrix is

$$\mathbf{B} = \begin{pmatrix} 1 & 2 & 0 \\ 2 & 1 & 3 \end{pmatrix}$$

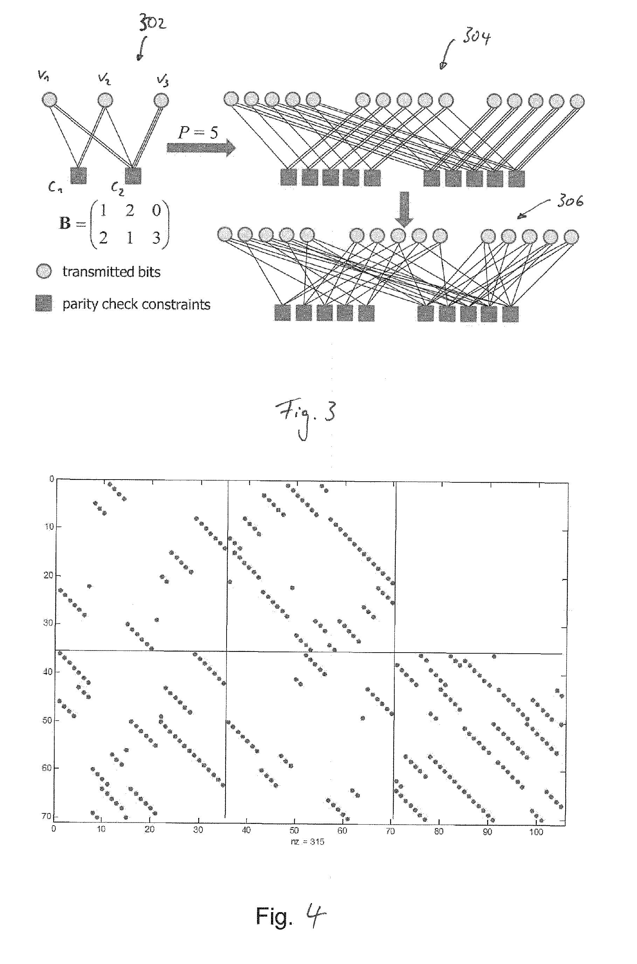

where the numbers or symbols in **B** denote the amount of parallel edges between the entries in the graph. Note that the permutation may be performed such that no parallel edges remain in the graph after permuting. **Fig. 3** shows an example of the copy-and-permute operation for generating a graph with $P$=5 using the example protomatrix **B**.

In Fig. 3, reference numeral 302 denotes a template graph, i.e., the protograph, for the protomatrix **B**. According to the entries of the first row of **B** there is one edge connecting variable node $v_1$ to check node $c_1$. Two edges are connecting variable node $v_2$ with check node $c_1$. Zero edges are between variable node $v_3$ and check node $c_1$. According to the entries of the second row of **B** there are two edges connecting variable node $v_1$ to check node $c_2$. One edge is connecting variable node $v_2$ with check node $c_2$. Three edges are between variable node $v_3$ and check node $c_2$. Reference numeral 304 denotes the graph resulting of the copy-operation with $P$=5 using protomatrix **B**. Finally, reference numeral 306 denotes the graph resulting of the permute-operation based on graph 304.

Most LDPC codes that are implemented today are so-called Quasi-Cyclic (QC) LDPC codes. They have a parity-check matrix **H** with a structure that allows for inherent parallelization of an LDPC decoder and leads to an efficient encoder realization. Almost all LDPC codes utilized in practice belong to the class of QC-LDPC codes.

QC-LDPC codes may be constructed using a so-called lifting matrix **A**. The parity-check matrix **H** may be constructed from the lifting matrix **A** by replacing each element of **A** with either an all-zero matrix of size $S{\times}S$ or a permutation matrix, e.g., a cyclically permuted identity matrix, of size $S{\times}S$. We adhere to the following notation: $S$ denotes the lifting factor, i.e., the size of the all-zero or cyclically shifted identity matrix. If the entry of **A** at row $m$ and column $i$ corresponds to a predetermined value, e.g., $A_{m,i}$ = -1, then the all-zero matrix of size $S{\times}S$ is used, and if $A_{m,i} \geq 0$, $A_{m,i}$ may denote how many cyclic right shifts of the identity matrix are performed. If dim(**H**) = $M{\times}N$, then dim(**A**) = $M'{\times}N'$, with $M'$=$M/S$ and $N'$=$N/S$. We furthermore define the set $\mathcal{N}_{\mathbf{A}}(m)$ to denote the positions of the non "-1" entries (or any other entry denoting a void replacement) in the $m$-th row of **A**, i.e., $\mathcal{N}_{\mathbf{A}}(m) = \{i: A_{m,i} \neq -1\}$.

Let us illustrate the construction of QC-LDPC codes by a small (artificial) example with a lifting matrix of size dim(**A**) = $3{\times}5$ and a lifting factor of $S$ = 5 (leading to dim(**H**) = $S{\cdot}$dim(**A**) = $15{\times}25$). This corresponds to a code of design rate $r$ = 0.4, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} =$$

Note that for the sake of clarity again only non-zero entries are show in the description of **H**. Note that **H** represents a binary matrix. The extension to an $x$-ary matrix for higher-order modulation can be achieved by replacing the non-zero elements by according non-zero elements of GF($x$) or $\mathbb{Z}_x$. The selection of the ring of integer numbers modulo $x$ is also frequently used in coded modulation. Both $\mathbb{Z}_x$ and GF($x$) are identical if $x$ is prime. Generally the value S corresponds to the parallelism that can be implemented in a QC-LDPC decoder.

In order to realize protograph-based QC-LDPC codes, we may employ a double-lifting procedure. First, from the protomatrix **B**, we may generate by the copy-and-permute operation a lifting matrix **A** and then optimize the non-void entries of **A** in order to get desired code properties. Using this lifting matrix **A**, we can then construct the parity-check-matrix **H** with the desired properties. We thus have dim(**H**) = $M''SP \times N''SP$, with dim(**B**)=$M'' \times N''$.

Let us illustrate the generation of an exemplary parity-check matrix **H** of a protograph-based QC-LDPC based on two-fold lifting by means of an example with $P$=5 and $S$=7. We start with the same exemplary protomatrix

$$\mathbf{B} = \begin{pmatrix} 1 & 2 & 0 \\ 2 & 1 & 3 \end{pmatrix},$$

which has been already introduced above and illustrated in Fig. 3. The $P$=5 cover shown in Fig. 3 of matrix **B** leads to a (parity-check) matrix **H**' that may be described by

$$\mathbf{H'} = \left( \begin{array}{ccccc|ccccc|ccccc}
1 & & & & & & 1 & 1 & & & & & & & \\
& & & & 1 & 1 & & & & 1 & & & & & \\
& & & 1 & & 1 & & & & 1 & & & & & \\
1 & & & & & & 1 & & & 1 & & & & & \\
& 1 & & & & & & 1 & 1 & & & & & & \\ \hline
1 & & & & 1 & & & 1 & & & 1 & 1 & 1 & & \\
1 & & 1 & & & & & & 1 & & 1 & & 1 & 1 & \\
& 1 & 1 & & & 1 & & & & & & 1 & 1 & 1 & \\
& 1 & & & 1 & & 1 & & & & 1 & 1 & & 1 & \\
& 1 & 1 & & & & & & 1 & & 1 & & & 1 & 1
\end{array} \right).$$

The bipartite graph 306 of the matrix **H**' is shown in the bottom right corner of Fig. 3. Note that the $P \times P$ squares of **H**' are filled with non-overlapping superpositions of permutation matrices preserving the number of "1"s per row and column of each $P \times P$ submatrix. Using the matrix **H**', we can get the lifting matrix **A** by properly selecting the cyclic shifts. An exemplary lifting matrix **A** is

$$\mathbf{A} = \left(\begin{array}{ccccc|ccccc|ccccc} -1 & 3 & -1 & -1 & -1 & -1 & 5 & 5 & -1 & -1 & -1 & -1 & -1 & -1 & -1 \\ -1 & -1 & -1 & -1 & 0 & 3 & -1 & -1 & 0 & -1 & -1 & -1 & -1 & -1 & -1 \\ -1 & -1 & -1 & 2 & -1 & 1 & -1 & -1 & -1 & 0 & -1 & -1 & -1 & -1 & -1 \\ 6 & -1 & -1 & -1 & -1 & -1 & 6 & -1 & -1 & 3 & -1 & -1 & -1 & -1 & -1 \\ -1 & -1 & 6 & -1 & -1 & -1 & -1 & 4 & 2 & -1 & -1 & -1 & -1 & -1 & -1 \\ \hline 0 & -1 & -1 & -1 & 0 & -1 & -1 & 2 & -1 & -1 & 5 & 4 & 6 & -1 & -1 \\ 4 & -1 & -1 & 1 & -1 & -1 & -1 & -1 & -1 & 1 & -1 & 2 & -1 & 0 & 5 \\ -1 & -1 & 1 & 0 & -1 & 0 & -1 & -1 & -1 & -1 & -1 & -1 & 6 & 6 & 6 \\ -1 & 4 & -1 & -1 & 0 & -1 & 4 & -1 & -1 & -1 & 2 & 0 & -1 & 6 & -1 \\ -1 & 2 & 1 & -1 & -1 & -1 & -1 & -1 & 5 & -1 & 0 & -1 & 0 & -1 & 3 \end{array}\right),$$

where the 1s of $\mathbf{H}'$ have been replaced by shift values in the range $\{0,1,...,S\text{-}1\}$ (here $S$=7) and the 0s (not shown in the description of $\mathbf{H}'$ for clarity) have been replaced by "-1". The resulting exemplary parity-check matrix $\mathbf{H}$ has dimension $2PS \times 3PS = 70 \times 105$ and is visualized in **Fig. 4**, with the single dots representing the non-zero elements of the matrix.

In order to construct an exemplary spatially coupled protograph-based LDPC code used to achieve a channel utilization of approximately 0.8 bit/channel use with a 3-PSK modulation scheme, for example, we may generate exemplary $\mathbf{H}_0$ and $\mathbf{H}_1$ using the following exemplary protographs $\mathbf{B}_0$ and $\mathbf{B}_1$:

$$\mathbf{B}_0 = (2 \quad 1)$$
$$\mathbf{B}_1 = (2 \quad 3)$$

This may lead to the exemplary protograph $\mathbf{B}_{conv}$ defining an embodiment of a spatially coupled/convolutional LDPC code. Note that the right element of $\mathbf{B}_0$ is 1 in some embodiments.

$$\mathbf{B}_{conv} = \left(\begin{array}{cccccccccc} 2 & 1 & & & & & & & & \\ 2 & 3 & 2 & 1 & & & & & & \\ & & 2 & 3 & 2 & 1 & & & & \\ & & & & 2 & 3 & 2 & 1 & & \\ & & & & & & 2 & 3 & 2 & 1 \\ & & & & & & & \ddots & \ddots & \ddots & \ddots \end{array}\right)$$

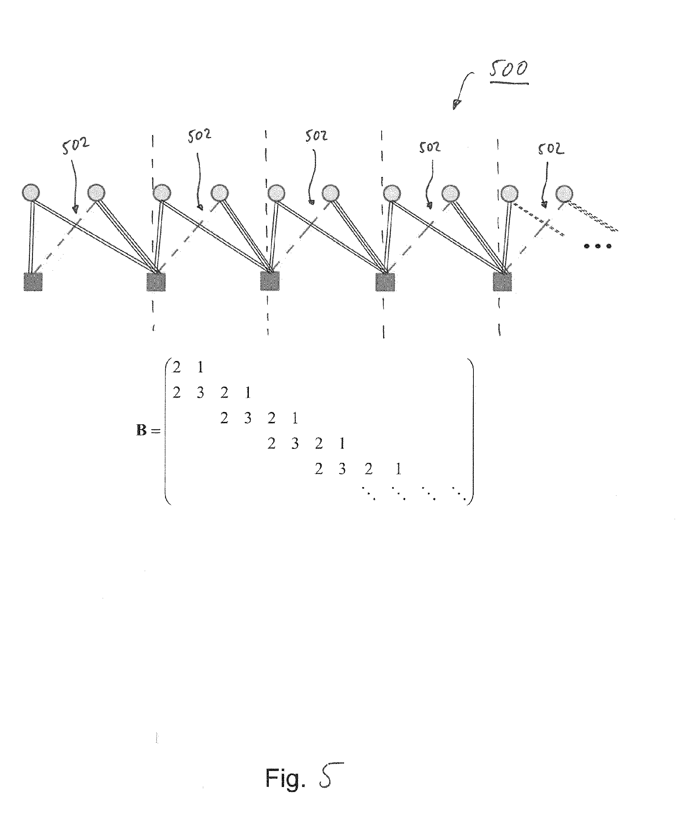

A protograph 500 corresponding to this exemplary protomatrix is shown in **Fig. 5**. The edges corresponding to a "1" in the protomatrix $\mathbf{B}_{conv}$ are marked by dashed lines 502 in Fig. 5. The reason for this is the following: We do not permute these edges in the copy-and-permute operation and in the lifting process to generate the QC-code. We replace these edges corresponding to a "1" in the protomatrix $\mathbf{B}_{conv}$ by an identity matrix. This structure may facilitate encoding.

Embodiments may be employed for binary or higher-order modulation schemes. The terminology higher-order modulation scheme denotes a digital modulation scheme that maps a group of $V$ bits with $V > 1$ to a single modulation symbol that encodes the $2^V$ possible values of the group of bits. In digital modulation, an analog carrier signal may be modulated by a discrete signal. The changes in the carrier signal are chosen from a finite number of $2^V$ alternative symbols defining the so-called modulation or symbol alphabet. In some embodiments, the digital modulation scheme may be a Quadrature Amplitude Modulation (QAM) scheme, such as 4-QAM, 8-QAM, 16-QAM, 32-QAM, 64-QAM, etc. Alternatively, the digital modulation scheme may be a Phase Shift Keying (PSK) scheme, such as QPSK, 8-PSK, 16-PSK, etc.

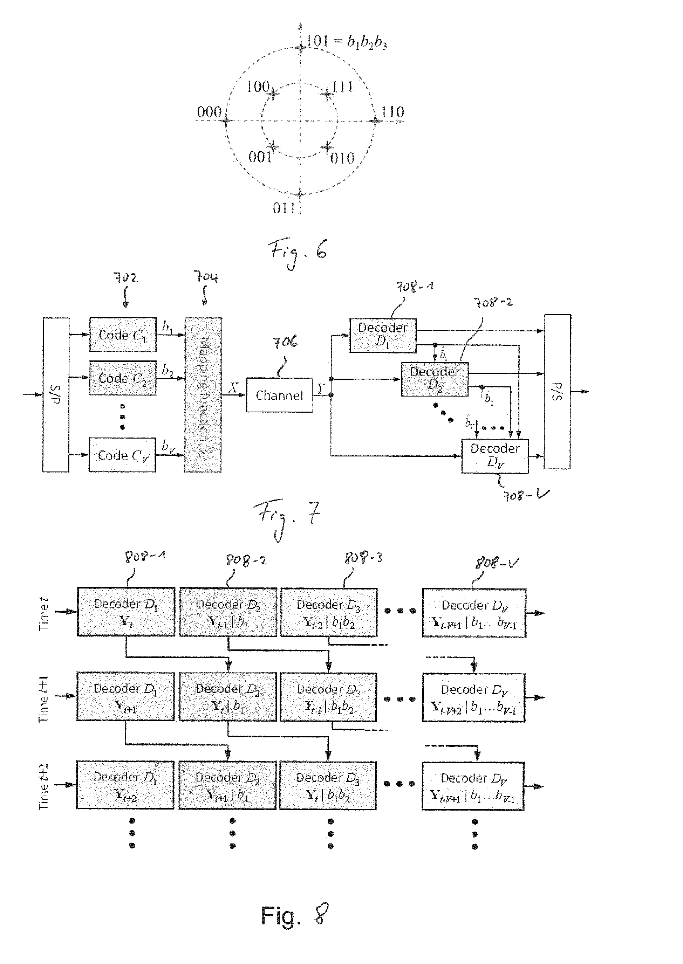

Let *V* denote the number of bits per modulation symbol *X*, and let **b** = ($b_1$, $b_2$,..., $b_V$) be a binary *V*-tuple. A one-to-one modulation mapping function $X = \varphi$ ($b_1$, $b_2$,..., $b_V$) maps **b** to a (complex) modulation symbol $X \in \mathbb{C}$. As an example, **Fig. 6** illustrates a constellation diagram of a mapping function $X = \varphi$ ($b_1$, $b_2$, $b_3$) for an 8-Phase Asymmetric Phase Shift Keying (8-APSK) constellation. By decomposing the mutual information between channel input *X* and channel output $Y \in \mathbb{C}$ using the chain rule of mutual information *I*, we obtain

$$I(X;Y) = I(b_1 b_2 \ldots b_V ;Y) = I(b_1 ;Y) + I(b_2 ;Y \mid b_1) + I(b_3 ;Y \mid b_1 b_2) + \cdots + I(b_V ;Y \mid b_1 b_2 \cdots b_{V-1}). =: C^{\mathrm{CM}}$$

This decomposition leads to an interpretation of the *V*-ary channel as *V* equivalent binary channels. The chain rule decomposition supports a multi-level coding scheme with a multi-stage decoder which is depicted in **Fig**. **7**.

Each of the *V* bits mapped to a constellation symbol *X* is individually encoded by a code $C_i$ of rate $R_{c,i}$ (702), mapped using $\varphi$ (704), and transmitted over a channel (706). At a receiver, a decoder $D_1$ (708-1) may first recover the bit(s) $b_1$ and the associated information bit sequence. Using the estimated value of $b_1$, a decoder $D_2$ (708-2) can then recover $b_2$ and so on until $b_V$ is recovered based on *Y* and the knowledge of $b_1$, $b_2$,...,$b_{V-1}$. Knowledge of $b_1$, $b_2$,....,$b_{i-1}$, at decoder $D_i$ means that the decoder $D_i$ only needs to consider $V / 2^{i-1}$ modulation symbols. With a set-partitioning mapping, for instance, the distances at each stage can then be increased. The task of a system designer is to select the rate $R_{c,i}$ of each single code $C_i$ such that the system performance is maximized.

At a first glance, the multi-stage decoder of Fig. 7 does not look too attractive due to the dependence of decoder $D_i$ on the *i*-1 previously decoded outputs. With a pipelined implementation, however, as shown in **Fig. 8**, the decoder utilization can be maximized and while decoder $D_2$ (808-2) decodes a frame from time instant *t* with the knowledge of $b_1$, the decoder $D_1$ (808-1) can already compute a new frame at time instant *t*+1. However, *V* different codes are needed for this system. Furthermore, the rates of the different codes can vary significantly and separate hardware for the *V* distinct decoders needs to be provided.

All capacity-approaching codes that are currently in use in optical communications, such as block-turbo codes and LDPC codes, have the property that the decoder complexity roughly scales with 1-$R_{c,i}$. The implementation of different codes of different rates with different encoders can be prohibitively complex in current and next-generation systems. The complexity of an LDPC decoder scales with the number of parity checks to be evaluated, i.e., with the overhead of the code. Additionally, the memory requirements and the interconnection and routing complexity for the parallel decoding pipeline shown in Fig. 8 may be prohibitively large.

Bit-Interleaved Coded Modulation (BICM) is frequently employed in many of today's communication systems. In contrast to Multi-Level Coding (MLC), where each equivalent bit channel requires its own code with its own rate, BICM only uses a single binary code, followed by a large bit interleaver. Using the mapping function $\varphi$, a bit stream of length *N* is partitioned into *N*/*V* *V*-tuples which are mapped to a modulation symbol sequence $Y \in \mathbb{C}^{[N/V]}$. The capacity of BICM may be expressed by:

$$C^{\mathrm{BICM}} = I(b_1 ;Y) + I(b_2 ;Y) + \cdots + I(b_V ;Y) \leq C^{\mathrm{CM}}.$$

The communication channel may be interpreted as *V* parallel, binary, non-interacting sub-channels. It has been shown that $C^{\mathrm{BICM}} \leq C^{\mathrm{CM}}$, i.e., employing the BICM scheme results in a capacity loss with respect to the coded modulation capacity constrained on the constellation $C^{\mathrm{CM}} = I(X, Y)$.

The capacity $C^{\mathrm{BICM}}$ of BICM strongly depends on the labeling that is used, i.e., the part of the mapping function $\varphi$ that defines the assignment of certain bit patterns to the modulation symbols. It may be shown that the well-known Gray mapping maximizes the BICM capacity $C^{\mathrm{BICM}}$. Gray mappings exist for most square constellations such as QPSK, 16-QAM, 64-QAM, and in these cases, the coded modulation capacity can be closely approached by BICM. There exist, however, modulation constellations which do not allow a Gray mapping. These include, for instance, the 8-QAM format (see Fig. 6) or ring constellation formats which are all popular formats in optical communications. As there are no closed form expressions for the BICM capacity $C^{\mathrm{BICM}}$ in the most widely used channels, a system designer may resort to numerical methods to find mappings that optimize the capacity. Popular methods include the bit switching algorithm. In this specification, we focus however on square constellation formats where a Gray mapping exists such that the BICM capacity $C^{BICM}$ closely approaches the coded modulation capacity $C^{CM}$.

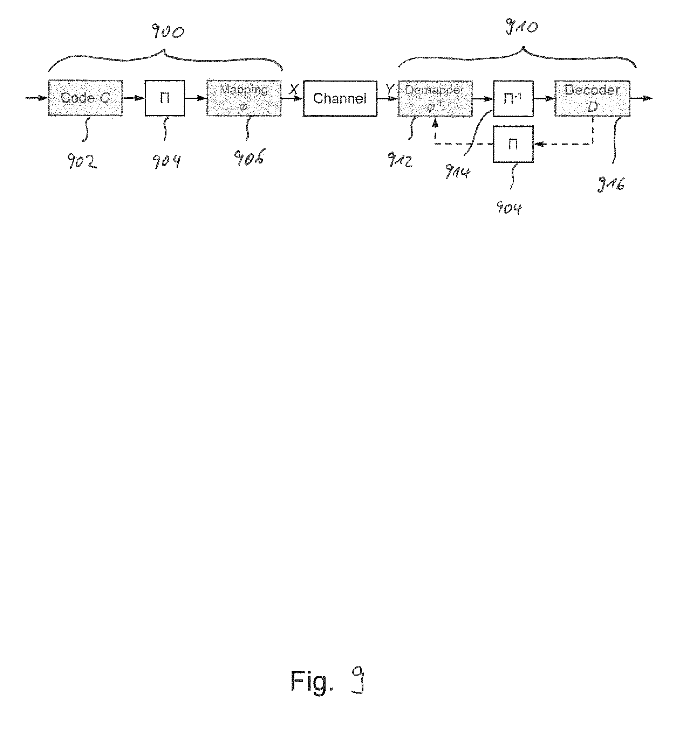

**Fig. 9** shows a simplified block diagram of a transmitter 900 and receiver 910 with BICM.

A channel encoder 902 and a modulator 906 are separated by a bit interleaver 904. At the receiver 910 a demodulator 912, also referred to as the demapper, provides either hard-decisions or soft outputs which are after proper deinterleaving 914 fed to a channel decoder 916. Bit-interleaved coded modulation with iterative decoding (BICM-ID) offers an attractive solution to partially recover the capacity loss $C^{CM}$-$C^{BICM}$ associated with BICM. In BICM-ID, the channel decoder 916 provides soft extrinsic feedback about the $N$ single bits of the code word, which are then fed back to the demodulator 912, which then provides updated soft a priori information about the code word bits in a subsequent decoding round. The feedback loop including the interleaver 904 is shown by the dashed lines in Fig. 9.

In the following, some example embodiments will be explained. Embodiments may rely on or be combined with techniques that have been explained above.

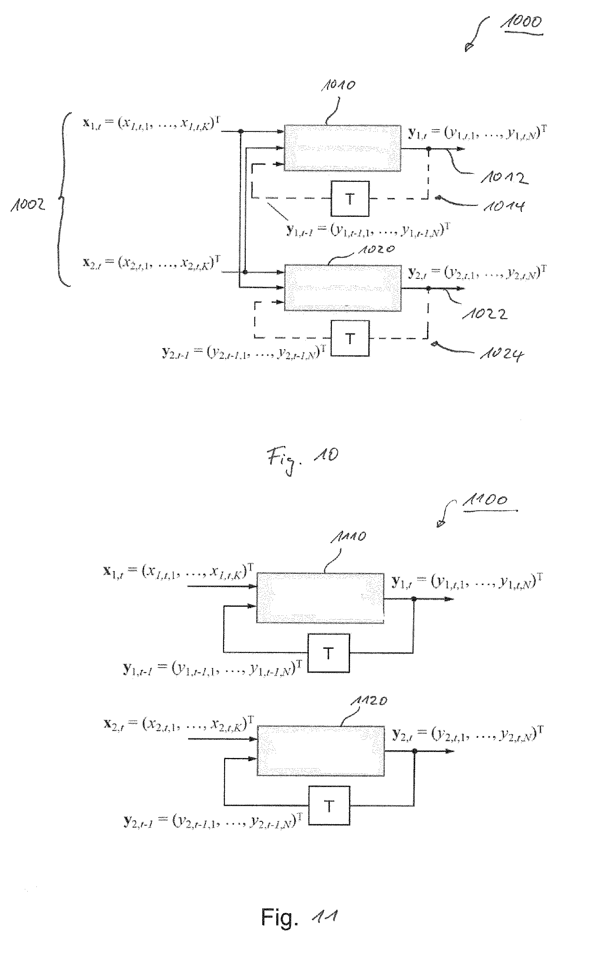

Turning now to **Fig. 10**, it is shown an LDPC encoder 1000 according to an embodiment. LDPC encoder 1000 may encode an input signal 1002. The input signal 1002 at time instant $t$ may comprise two input signal components $\mathbf{x}_{1,t}$ and $\mathbf{x}_{2,t}$. The two signal components $\mathbf{x}_{1,t}$ and $\mathbf{x}_{2,t}$ may be vectors of $K$ information symbols, respectively.

The LDPC encoder 1000 comprises a first LDPC encoder entity 1010 which is configured to provide, in accordance with a first LDPC encoding rule, a first encoded output signal 1012 ($\mathbf{y}_{1,t}$) based on the input signal 1002 or the two input signal components $\mathbf{x}_{1,t}$ and $\mathbf{x}_{2,t}$ thereof. The LDPC encoder 1000 further comprises a second LDPC encoder entity 1020 which is configured to provide, in accordance with a second LDPC encoding rule, a second encoded output signal 1022 ($\mathbf{y}_{2,t}$) based on the input signal 1002 or the two input signal components $\mathbf{x}_{1,t}$ and $\mathbf{x}_{2,t}$ thereof. A first bipartite graph corresponding to the first LDPC encoding rule of the first encoder entity 1010 is coupled to a second bipartite graph corresponding to the second LDPC encoding rule of the second encoder entity 1020 via one or more shared nodes among the first and the second bipartite graph. Thereby the shared nodes interconnect the first and the second bipartite graph.

The skilled person having benefit from the present specification will appreciate that the first and the second encoder entities 1010, 1020 are not necessarily physically separate instances. Instead, they may in fact be implemented by means of a single software or hardware device. As will be appreciated the first and the second encoder entities 1010, 1020 may be regarded as two interconnected coding chains. Also, the skilled person will appreciate that embodiments are not limited to two encoder entities. Embodiments may well include more than two interconnected coding chains.

The LDPC encoder 1000 may perform a method for encoding the input signal 1002. The method comprises encoding the input signal 1002 (or the two input signal components $\mathbf{x}_{1,t}$ and $\mathbf{x}_{2,t}$ thereof) in accordance with a first LDPC encoding rule to obtain a first encoded output signal, and encoding the input signal 1002 (or the two input signal components $\mathbf{x}_{1,t}$ and $\mathbf{x}_{2,t}$ thereof) in accordance with a second LDPC encoding rule to obtain a second encoded output signal. A first bipartite graph corresponding to the first LDPC encoding rule is coupled or connected to a second bipartite graph corresponding to the second LDPC encoding rule via one or more nodes interconnecting the first and the second bipartite graph.

For comparison, a conventional LDPC encoder 1100 without said coupling between bipartite graphs is illustrated in **Fig. 11**. It can be seen that, in contrast to Fig. 10, that the two input signal components $\mathbf{x}_{1,t}$ and $\mathbf{x}_{2,t}$ are solely fed to their associated encoder entities or coding chains 1110 and 1120, respectively, and are encoded separately from each other. Hence, parity bits of $\mathbf{y}_{1,t}$ are only based on $\mathbf{x}_{1,t}$ and parity bits of $\mathbf{y}_{2,t}$ are only based on $\mathbf{x}_{2,t}$. In contrast, according to embodiments of the LDPC encoder 1000, the two input signal components $\mathbf{x}_{1,t}$ and $\mathbf{x}_{2,t}$ are encoded depending on each other. That is to say, parity bits of $\mathbf{y}_{1,t}$ are based on $\mathbf{x}_{1,t}$ and $\mathbf{x}_{2,t}$ and parity bits of $\mathbf{y}_{2,t}$ are based on $\mathbf{x}_{2,t}$ and $\mathbf{x}_{1,t}$.

In some embodiments the first and the second LDPC encoding rules correspond to LDPC convolutional encoding rules, respectively. In other words, the first bipartite graph may correspond to a first coding chain which is corresponding to a first LDPC convolutional encoding rule. The second bipartite graph may correspond to a second coding chain which is corresponding to a second LDPC convolutional encoding rule. Thereby the first and the second coding chain may share at least one variable node and/or at least one check node in order to couple or interconnect the first and the second coding chain.

Hence, in some embodiments the first and the second LDPC encoder entities 1010 and 1020 may be LDPC convolutional encoder entities, respectively. In this case, a delayed version of the encoded output signals 1012 and 1022 may be fed back to the respective encoder inputs. This is indicated by the optional dashed feedback paths 1014 and 1024 in Fig. 10. In case of LDPC convolutional encoders the input to the first encoder entity 1010 at time instant t may be the input signal(s) $\mathbf{x}_{1,t}$ and $\mathbf{x}_{2,t}$ as well as the delayed first output signal $\mathbf{y}_{1,t-1}$ (and, if $\mu > 1$, $\mathbf{y}_{1,t-1}, ..., \mathbf{y}_{1,t-\mu}$). Likewise, the input to the second encoder entity 1020 at time instant t may be the input signal(s) $\mathbf{x}_{1,t}$ and $\mathbf{x}_{2,t}$ as well as the delayed second output signal $\mathbf{y}_{2,t-1}$ (and, if $\mu > 1$, $\mathbf{y}_{1,t-1}, ..., \mathbf{y}_{1,t-\mu}$).

In the context of Spatially Coupled LDPC (SC-LDPC) or LDPC convolutional codes the term "coding chain" may frequently be employed to designate the structure of an extended protograph or Tanner graph of convolutional or spatially coupled LDPC codes. In particular when time-invariant LDPC codes are used, the appearance of the protograph has a repetitive structure, similar to the links of a chain. Fig. 5 shows a typical example of a coding chain where always two variable nodes in the protograph 500 form a single link of the chain. In total five links are shown in Fig. 5. In the context of the present specification a coding chain may designate a protograph that comprises repeating elements or links that are connected in a repetitive way. Each link comprises one or several variable nodes and one or several check nodes. At least one edge connecting one variable node of a link at position $k$ connecting one check node at position $k+j$ (usually $j$=1 or $j$=-1) is required.

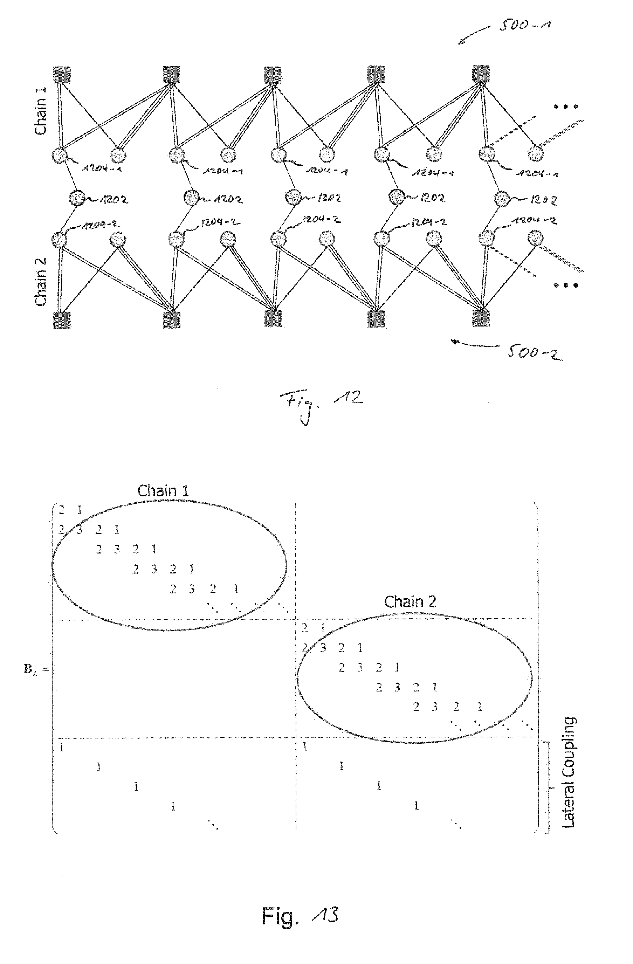

Embodiments include several levels of coupling. We commence by introducing and showing lateral coupling on protograph level. Thereby we start, for example, with the protograph chain 500 shown in Fig. 5 and place two of these chains vertically next to each other and flip the upper chain vertically to ease visibility. The resulting protograph including two coupled sub-protographs 500-1 and 500-2 is shown in **Fig 12**.

We introduce coupling by placing additional degree-2 nodes (two edges) 1202 between the coding chains 500-1 and 500-2, and by connecting one edge of these shared nodes 1202 to a variable node 1204-1 of the top protograph 500-1 and one edge to a variable node 1204-2 of the bottom protograph 500-2. In the example of Fig. 12 the shared nodes 1202 are assigned to both the first and the second bipartite graph 500-1 and 500-2. Note that the newly introduced coupling nodes 1202 enforce that the connected variable nodes 1204-1 and 1204-2 of both chains 500-1 and 500-2 are equal, i.e., have the same value. Further note that variable nodes of degree 2 as well as check nodes of degree 2 (i.e., two connected edges) are equal and both enforce that the connected nodes be equal. Therefore, we only refer to as additional coupling nodes.

The coupling may enforce that several (parity) bits of the two coding chains are equal, i.e., we may realize a sort of repetition coding. The repeated bits can either be both transmitted to achieve a kind of diversity, or one of the repeated bits can be punctured for reducing the rate loss. Hence, the first encoded output signal 1012 may comprise at least one first parity bit coupled to at least one identical second parity bit of the second encoded output signal 1022. The LDPC encoder 1000 may be configured to puncture the first or the second parity bit.

An equivalent protomatrix $\mathbf{B}_L$ of the protograph of Fig. 12 is shown in **Fig. 13**. In this matrix representation we interpret the additional coupling nodes or shared nodes 1202 as additional check nodes (rows), which are placed at the bottom of the protomatrix $\mathbf{B}_L$. From Fig. 13 it may be seen that the left part of the protomatrix $\mathbf{B}_L$ corresponds to chain 1 and, hence, to input signal component $\mathbf{x}_{1,t}$ and output signal component $\mathbf{y}_{1,t}$. The right part of the protomatrix $\mathbf{B}_L$ corresponds to chain 2 and, hence, to input signal component $\mathbf{x}_{2,t}$ and output signal component $\mathbf{y}_{2,t}$. The additional rows of protomatrix $\mathbf{B}_L$ corresponding to the lateral coupling lead to parity bits of $\mathbf{y}_{1,t}$ being based on $\mathbf{x}_{1,t}$ and $\mathbf{x}_{2,t}$ and parity bits of $\mathbf{y}_{2,t}$ being based on $\mathbf{x}_{2,t}$ and $\mathbf{x}_{1,t}$. Recall that the rate of the code is 1-$M/N$ if dim($\mathbf{B}_L$) = $M \times N$. Due to the relatively large increase of $M$ due to coupling, the lateral coupling as shown here may incur in a rate loss.

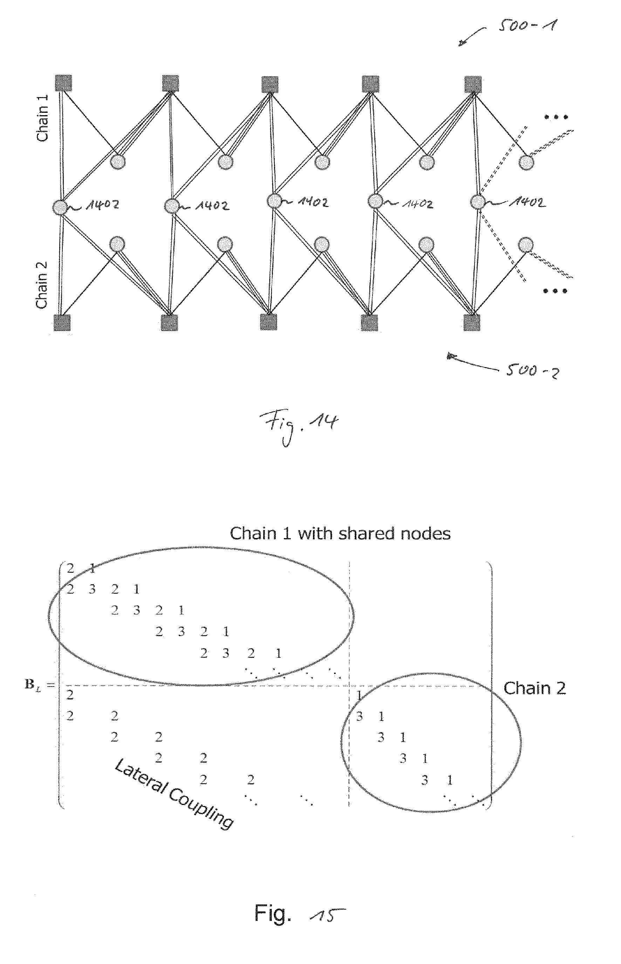

If we choose not to repeat the coupled values, we can also draw the coupled protograph of Fig 12 as shown in **Fig. 14**. In this case, we have combined the two laterally connected variable nodes 1204-1 and 1204-2 of Fig. 12 to a single shared variable node 1402 of larger degree (degree-8). The equivalent protomatrix $\mathbf{B}_L$ is shown in **Fig. 15**. Here we have assigned all the shared variable nodes to the first chain 500-1. That is to say, in some embodiments a shared node may be assigned to either the first 500-1 or the second bipartite graph 500-2. Again, we observe a rate loss of the code by the change of the size of the protomatrix.

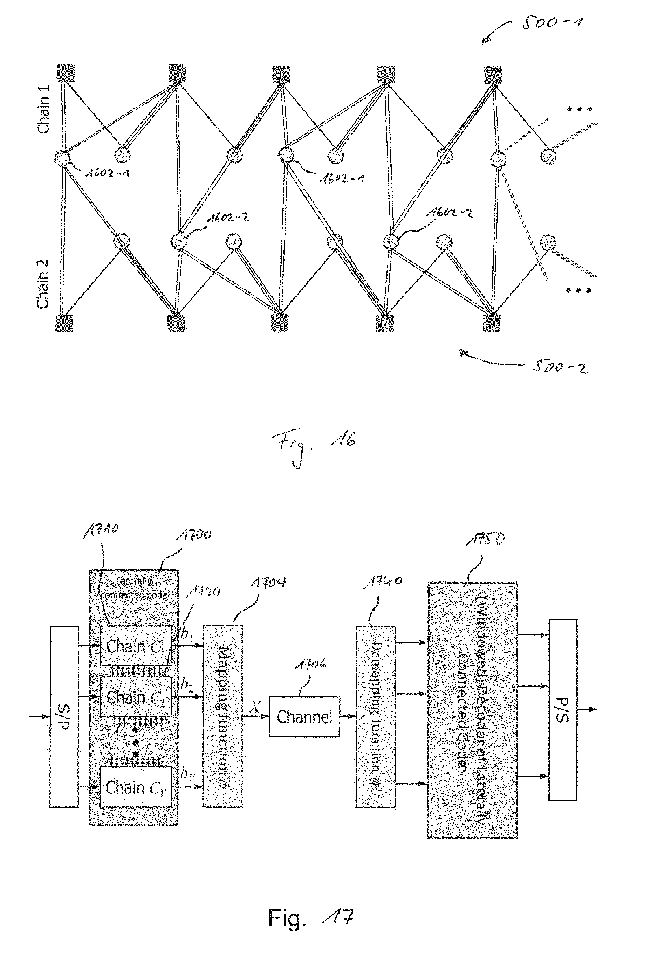

If we wish to achieve a balanced distribution of the code bits to both chains 500-1 and 500-2, we can alternatively distribute the laterally coupled nodes to either chain, as shown in **Fig. 16**. Here, the shared variable nodes 1602-1, 1602-2 are alternately assigned to the first chain 500-1 and to the second chain 500-2. Such sort of distribution may be important if we consider the application of the proposed coding scheme to coded modulation schemes as shown in **Fig. 17**, where the streams that are to be encoded with either chain have the same length.

Fig. 17 shows an application of the proposed LDPC coding scheme to a higher order modulation scheme, such as, e.g., 16-QAM, in a first BICM-like way. In this case, we set $C = V$, i.e., the number of coding chains corresponds to the number of bits per modulation symbol.

An LDPC encoder 1700 comprises $V$ coupled LDPC encoder entities 1710, 1720, etc., wherein the bipartite graphs (or coding chains) corresponding to different LDPC encoding rules of different encoder entities are coupled (interconnected) to each other. Thereby, coupling only between neighboring encoder entities may be foreseen and/or coupling between arbitrary of the $V$ LDPC encoder entities. That is to say, each of the $V$ bits $b_1$, $b_2$,...,$b_V$ mapped to a constellation symbol $X$ may be individually encoded by an associated coding chain 1710, 1720, etc., mapped using $\varphi$ (1704), and transmitted over a channel 1706. That is to say, we multiplex the output of the different chains to the mapping functions which generates the modulation symbols.

Considering the BICM partition of the channel $C^{BICM} = I(b_1; Y) + 1(b_2; Y) + \cdots + I(b_V; Y)$, we see that each additive term of that decomposition corresponds to one chain of the code. Note that in most modulation formats the terms are not equal, for instance in 16-QAM with Gray mapping, two distinct terms appear, which means that the rates of the different chains may be chosen accordingly. By assigning the shared nodes to the different chains accordingly, this difference in the rate may be efficiently accounted for. The lateral coupling between the LDPC encoder entities 1710, 1720, etc. advantageously offers that some systematic errors causing only some bits to be wrongly decoded or showing a worse performance, can still be robustly recovered. One such example is a receiver with bad scaling of the I-Q plane, such that for instance, the real or imaginary axis of the symbols shows a worse error rate than the other axis. In such a scenario, half of the bits, i.e., also half of the chains show a worse performance. By lateral coupling, the robustness may then be improved.

At a receiver, a demodulator 1740, also referred to as the demapper, may provide either hard-decisions or soft outputs which are fed to an LDPC channel decoder 1750. Corresponding to the laterally coupled LDPC encoder 1700, the LDPC decoder 1750 may comprise *V* laterally coupled LDPC decoder entities. Thereby, a first decoder entity may be operable to provide, in accordance with a first LDPC decoding rule, a first decoded output signal based the encoded input signal. A second decoder entity may be operable to provide, in accordance with a second LDPC decoding rule, a second decoded output signal based the encoded input signal. A first bipartite graph corresponding to the first LDPC decoding rule may be coupled to a second bipartite graph corresponding to the second LDPC decoding rule via one or more shared nodes among the first and the second bipartite graph. By including the demapping function 1740 into a windowed decoder and a correspondingly optimized code construction, a multi-level coding scheme with multi-stage decoding is also possible.

The skilled person having benefit from the present specification will appreciate that the first and the second decoder entities are not necessarily physically separate instances. Instead, they may in fact be implemented by means of a single software or hardware device. As will be appreciated the first and the second decoder entities may be regarded as two interconnected decoding chains. Also, the skilled person will appreciate that embodiments are not limited to two decoder entities. Embodiments may well include more than two interconnected decoding chains, as can be seen from Fig. 17.

Embodiments work with a plurality ($\geq$ 2) of laterally coupled (de-)coding chains. Hence, we can extend embodiments easily to a higher number of coupled chains. If C denotes the number of coupled chains, we can think of two different coupling schemes:

1) Coupling into to the neighboring chain. The shared coupled nodes can only connect chains *j* and *j*+1. We might or might not allow for cyclic lateral coupling in which case, chains 1 and *C* can also be connected.
2) Lateral coupling is allowed between any chain.

Note that we may impose an important restriction on the lateral coupling which may have some practical implications. Usually LDPC convolutional codes have a temporal dependency. We might partition the stream of input symbols at chain *j* into a plurality of chunks $\mathbf{x}_{j,t}$, as illustrated in Fig. 10. In a conventional, laterally uncoupled LDPC convolutional code (see Fig. 11), the output chunk $\mathbf{y}_{j,t}$ at time *t* and for chain *j* is a function of the current input $\mathbf{x}_{j,t}$ and one or more previous output chunks, i.e., $\mathbf{y}_{j,t} = f(\mathbf{x}_{j,t}, \mathbf{y}_{j,t-1},..., \mathbf{y}_{j,t-\mu})$, with $\mu$ being the syndrome former memory of the code. The difference between laterally uncoupled and laterally coupled code encoders is shown in Figs. 10 and 11: Fig. 11 shows the encoders of two laterally uncoupled coding chains, while a laterally coupled version is shown in Fig. 10. Note that, as described, the inputs of each chain depend on the actual and on the neighboring chain of the current time instant *t* only, i.e., $\mathbf{y}_{j,t} = f(\mathbf{x}_{j,t}, \mathbf{x}_{3-j,t}, \mathbf{y}_{j,t-1},..., \mathbf{y}_{j,t-m}) = f(\mathbf{x}_{1,t}, \mathbf{x}_{2,t}, \mathbf{y}_{j,t-1},..., \mathbf{y}_{j,t-m})$ for the coupled case in Fig. 10. Hence, our proposed coding scheme uses codes that have are coupled at each time instant. We thus have concurrent coding chains that present a coupling at each time instant.

In other words, the first and the second bipartite graph are coupled at each time instant *t* via at least one variable node and/or at least one check node.

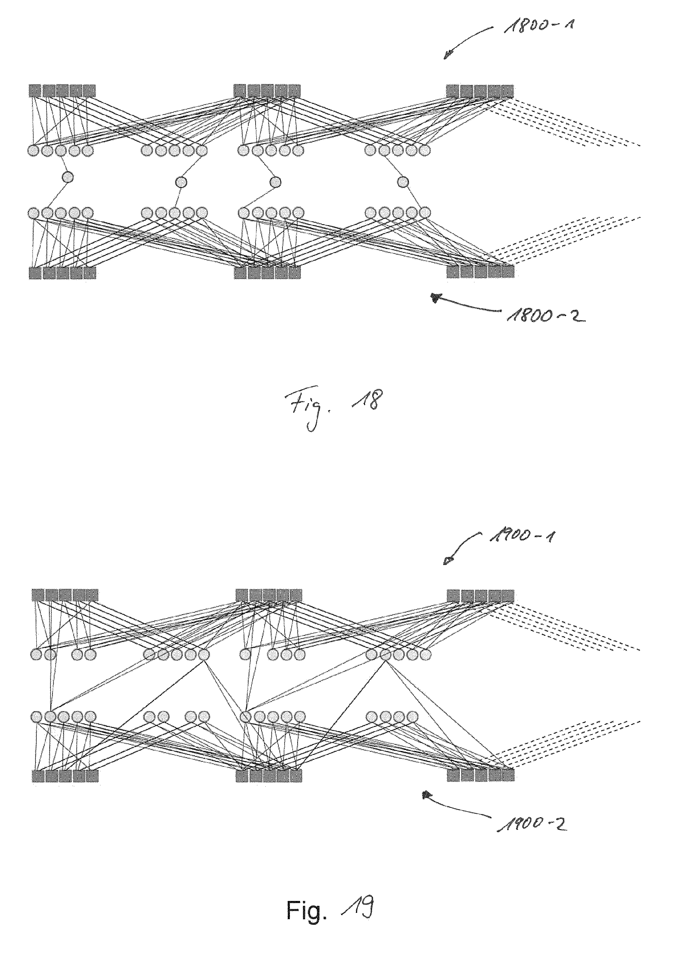

Note that the rate loss that incurs with the present code construction might not be acceptable in practical constructions. There are several possibilities to construct laterally coupled LDPC codes with reduced rate loss. A first of these methods may be to use a protograph with finer granularity. As the proposed lateral coupling may include at least a single shared variable node, increasing the number of variable nodes may help to allow for a finer granularity. For instance, one could use a double lifting procedure as shown in Fig. 3 and Fig. 4, to get an intermediate protograph which is interpreted as a QC code. In this case, the lateral coupling can be performed on the size of cyclic shift matrix of the QC code. Such a lateral coupling on an intermediate protograph is shown exemplarily in **Fig. 18**, where we show two laterally coupled code chains 1800-1 and 1800-2 obtained from an intermediate protograph by a *P*=5 cover of a smaller protograph (see also Fig. 3). While with the construction in Fig. 12 the rate of the code is decreased from $R_{\text{uncoupled}}$ = ½ to $R_{\text{lat.coupl.}}$ = 1/3, we have a moderate rate loss from $R_{\text{uncoupled}}$ = ½ to $R_{\text{lat.coupl.}}$= 0.444444 in Fig. 18.

Again, in **Fig. 19** we show an example where do not use shared nodes and repeated diversity transmission of the laterally coupled variables but a case where we remove the shared nodes (assigned to both chains 1900-1 and 1900-2) and only transmit one of the coupled nodes (with increased edge count), similar to Fig. 16. Again, we alternatingly assign the laterally coupled nodes to either chain to achieve a more uniform distribution of the code bits to both chains. That is to say, a coupling node is assigned to either the first or the second bipartite graph 1900-1 or 1900-2. Note that this method includes replacing the entries related to lateral coupling in the protomatrix (see Fig. 13 and Fig. 15) not by

a $P \times P$ permutation matrix but rather by a $P \times P$ matrix **C'** which has row weight $C_p < P$, column weight $C_p < P$ and a constraint that no row and column contains more than a single "1". We can think of this additional way of laterally coupling with the goal of reducing the rate loss as the introduction of the concept of partial lifting. The concept of partial lifting is best explained using the protomatrix of Fig. 13. In this case, the "1"s in the lower part of the protomatrix related to the lateral coupling are not replaced by a $P \times P$ permutation matrix but rather by a partial permutation matrix. In the examples in Fig. 18 and Fig. 19, we have $C_p = 1$.

An additional way of further reducing rate loss may be to use partial lifting in the second lifting procedure (or in the only lifting procedure, if only one lifting process is executed). This second lifting procedure may correspond to the lifting of a lifting matrix **A** as in the example above, to generate a QC code. In this case too, we can generate the final parity check matrix by the above mentioned replacement/lifting procedure where the entry responsible for coupling is replaced by a permutation matrix with row and column weight $C_s < S$ and the constraint that no row and no column contains more than a single "1". For implementational convenience, cyclically shifted identity matrices may be used. This allows using barrel shifter circuits at memory interfaces in a decoder implementation. In this case, we may use a matrix **C'** which has "1" in those $C_s$ positions that correspond to the cyclically shifted identity matrix. An example of such a matrix **C'** of size $S \times S$ with $S=7$ and $C_s=3$ which correspond to a right shift of 2 (corresponding entry in **A**) is given by (only some zeros are shown for convenience, void entries are assumed to be zero):

$$\mathbf{C'}=\begin{pmatrix} & & & 0 & & & \\ & & & & 1 & & \\ & & & & & 0 & \\ & & & & & & 0 \\ & & & & & & & 1 \\ 1 & & & & & & \\ & 0 & & & & & \end{pmatrix}.$$

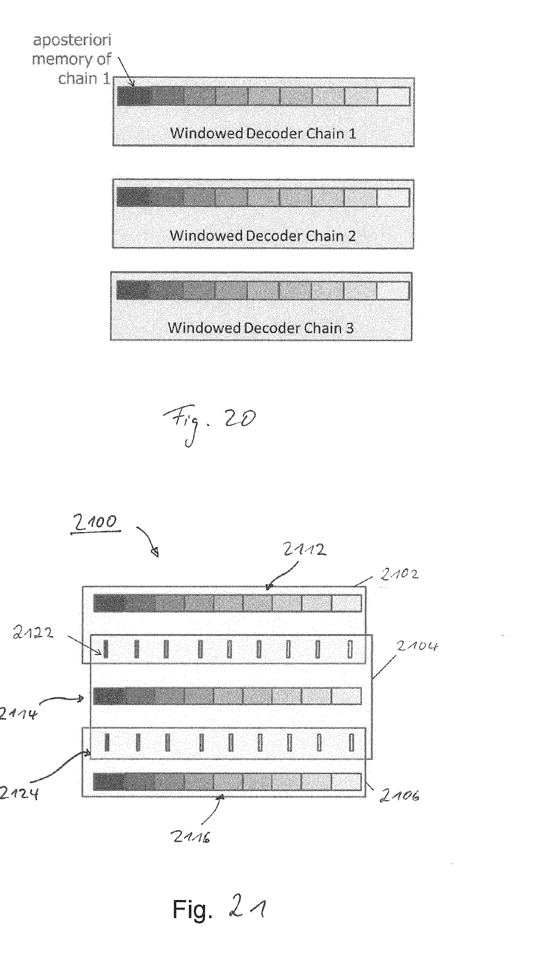

If we consider the conventional case of multiple parallel laterally uncoupled chains of codes, e.g., corresponding to the encoder shown in Fig. 11, we may employ multiple windowed decoders for the single chains as shown in **Fig. 20,** where for example three instances of decoders run on parallel on three different uncoupled coding chains. If we now allow for an embodiment of the proposed lateral coupling, where each chain can only couple to its direct neighbor (without cyclic unwrapping, i.e., chains 1 and C are uncoupled), we can modify the decoders as shown in **Fig. 21**.

Fig. 21 shows an LDPC decoder 2100 comprising three laterally coupled (de-)coding chains 2102, 2104, and 2106. The LDPC decoder 2100 includes a first decoder entity which is operable to provide, in accordance with the first LDPC decoding or code chain 2102, a first decoded output signal based on an encoded input signal. The LDPC decoder 2100 includes a second decoder entity which is operable to provide, in accordance with the second LDPC code chain 2104, a second decoded output signal based the encoded input signal. The LDPC decoder 2100 further includes a third decoder entity which is operable to provide, in accordance with the third LDPC code chain 2106, a third decoded output signal based the encoded input signal. According to embodiments, the first, the second, and the third LDPC decoding chains 2102, 2104, and 2106 are coupled to each other.

Instead of having dedicated, non-interacting a-posteriori / LLR memory $\hat{\mathbf{z}}^{[\text{Chain } i]}$ for all three chains 2102, 2104, and 2106, we may now deploy two kinds of memory: First, we still have dedicated LLR memories 2112, 2114, and 2116 for all three decoder entities which are only accessed by the respective decoder entity 2102, 2104, and 2106 itself. This non-interacting LLR memory 2112, 2114, and 2116 is assigned to all of the non-shared variable nodes, i.e., those nodes not taking part in the lateral coupling. The second kind of memory 2122, 2124 is an interacting a-posteriori / LLR memory dedicated to the shared, i.e., laterally coupled variable nodes. This interacting or shared memory 2122, 2124 may be accessed by the two decoders of the chains that are connected to these nodes. In the example of Fig. 21, memory 2122 may be accessed by the coupled decoder entities 2102 and 2104, while memory 2124 may be accessed by the coupled decoder entities 2104 and 2106. By proper scheduling of the operations inside the decoder entities 2102, 2104, and 2106 and by corresponding code (i.e., parity check matrix) design, we can assure that no two decoder entities access at the same time to such a shared memory location.

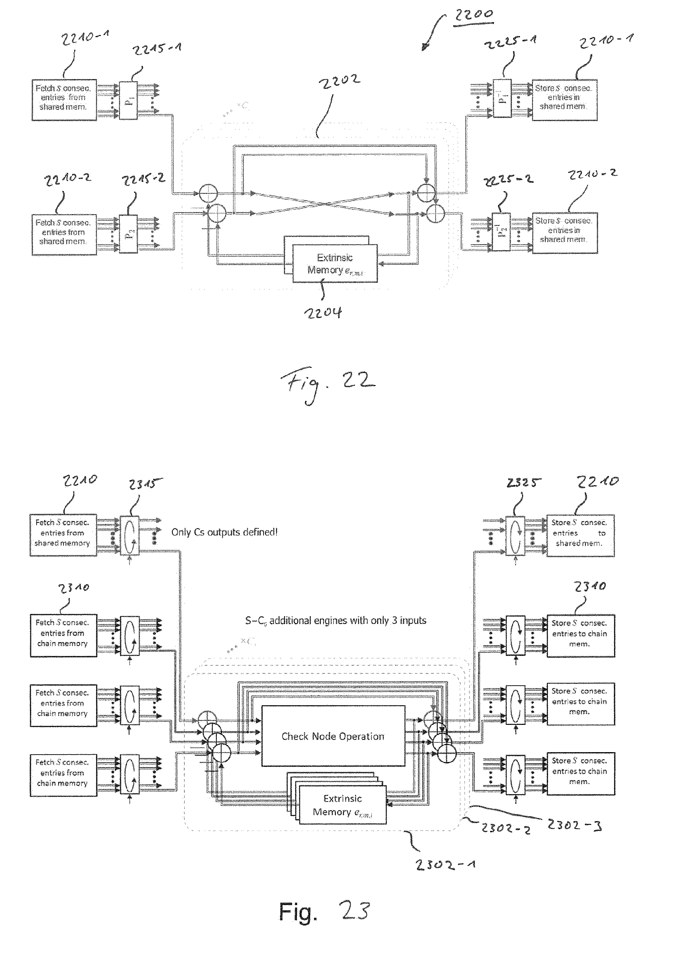

If we take for instance the protomatrix as shown in Fig. 13, where we may assume a diversity transmission of parity symbols corresponding to the laterally coupled nodes, we may execute two conventional windowed decoders based on the aforementioned layered decoding algorithm operating in parallel on the parts of the matrix corresponding to chain 1 and chain 2. Note that the LLR memory corresponding to the first, third, fifth, ... variable nodes of the protograph of each chain needs to be realized as interacting LLR memory, while the LLR memory corresponding to the even protograph variable node positions can be realized as non-interacting LLR memory. After these windowed decoders have finished, for example, we may execute an extra check node processing unit that takes into account the bottom part of the protomatrix of Fig. 13. This extra check node processor unit 2200 is shown in **Fig. 22.**

Due to the QC structure of the parity check matrix **H**, the extra check node processor unit 2200 can process always S rows of **H** in parallel as these computations are independent. This parallelism is necessary to be able to operate at decoding speeds of 100Gbit/s and above. Instead of decoding each row of **H**, the extra check node processor unit 2200 for laterally coupled QC LDPC codes may decode each row of a corresponding lifting matrix **A** by decoding $S$ (or $C_s$ in the case of partial lifting) rows of **H** in parallel.

The decoding circuitry setup for decoding the rows of **H** corresponding to the bottom part of the protomatrix of Fig. 13 is shown in Fig. 22. Decoding the first row of the bottom part of the protomatrix corresponds to decoding, for example, the first $S$ rows of the bottom part of **H**. Note that $S = C_s$ in this example, such that $C_s$ modified check node decoding circuits 2202-1 to 2202-$C_s$ can be deployed in parallel. In the left part of the circuit shown in Fig. 22, memory fetching circuits 2210 each retrieve $S$ neighboring values $\hat{z}_i$ of the shared a-posteriori memory. These may then be processed by associated shifting circuits 2215 (which can be realized using barrel shifters) to account for the cyclic shifting nature of **H**. The individual outputs of the shifters 2215 are then fed to modified check node operations 2202, and the outputs of the parallel modified check node circuits 2202-s ($s$ = 1 ... $S$) are gathered and then fed to a bank of inverse shifters 2225, that are configured using the same values but perform cyclic right-shifts of the $S$ values at their inputs. These are then stored again in the shared a-posteriori / LLR memory 2210.

Note that the check node operations 2202-$s$ simplify extremely in this case compared to the conventional case of Fig. 1, as the check node operation involving only two shared or coupled nodes simply consists of swapping the inputs. That is to say, compared to equations (2) to (6) the modified extra check node operation corresponding to shared nodes may be expressed as (with $i \in \{1,2\}$)

$$(a) \qquad t_{m,i} = \hat{z}_{J(m,i)} - e_{m,i}^{(l)}$$

$$(b) \qquad e_{m,i}^{(l+1)} = t_{m,3-i} \qquad\qquad , \text{e.g.,}\ e_{m,1}^{(l+1)} = t_{m,2}\ \text{and}\ e_{m,2}^{(l+1)} = t_{m,1}$$

$$(c) \qquad \hat{z}_{J(m,i)} = t_{m,i} + e_{m,i}^{(l+1)} \qquad\qquad , \text{note that}\ \hat{z}_{J(m,1)} = \hat{z}_{J(m,2)} = t_{m,1} + t_{m,2}$$

with $J(m,i)$ denoting a function that assigns the correct LLR memory index based on the shared node index m and the associated edge $i \in \{1,2\}$. Note that both outputs are equal which can be used to further simplify the circuit.

Note that we used the most generic realization of circuit using permutation matrices $P_1$ and $P_2$ instead of barrel shifters, but if the matrices $P_1$ and $P_2$ are cyclically shifted identity matrices, we can of course replace the permutation circuits by shifters. Note that the circuit of Fig. 22 is not restricted to the diversity transmission case, but can also be used in a more general case by puncturing some of the shared nodes. In this case, the associated LLR memory entries are not initialized with the channel values but are initialized with the "zero" LLR value denoting that no channel-related information is available. Further note that partial lifting is taken into account here by only having $C_s$ instead of S parallel instances of the check node (i.e., swap) unit here. This realization of a decoder has the advantage that an existing decoder can be mostly reused and only a smaller extra part corresponding to the coupling has to be added.

If we consider the (equivalent) protomatrix of Fig. 15, this representation leads to a different decoder realization, as shown in **Fig. 23.** In this case, we denote the LLR / a-posteriori memory 2310 that is only accessed by one single decoder entity 2302-$s$ ($s$ = 1 ... $S$) from one chain as "chain memory". The layered decoding engine has possibly some connections to the chain memory 2310 and some connections to the shared memory 2210 (corresponding to shared nodes) to account for the lateral coupling. Note that a parallel decoding of the chains is possible if the check node execution is optimized such that no concurrent memory accesses by two decoding engines to a single shared memory location occur. The shifters 2315 that are connected to the shared memory may only have $C_s$ outputs if partial lifting is used. In this case, we may have $C_s$ decoder entities 2302-s (s = 1... $C_s$) that have connections to the shared memory 2210 as well as to the chain memory 2310 and $S$-$C_s$ decoder entities 2302-s (s = $C_s$+1 ... $S$) that are only connected to the chain memory 2310.

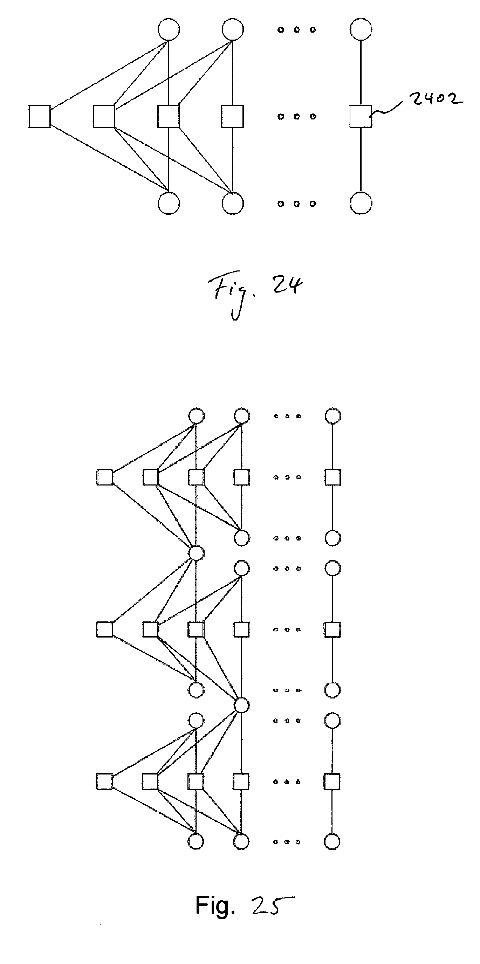

For an analysis a probabilistically coupled ensemble may be used. In this case, random uncoupled Tanner graphs may be constructed. Based on an integer coupling parameter $w$, we may take each of one of the Tanner graph, and swap it with probability $1/w$ with an edge from one of the w neighboring graphs. For instance, if $w = 3$, we either leave the edge in the current graph with probability 1/3, or we connect it with corresponding node from the neighboring graph on the left (in the temporal dimension) with probability 1/3 or with the corresponding node from the neighboring graph on the right with probability 1/3. Such a graph is shown exemplarily in **Fig. 24**. With the lateral coupling, we place several (i.e., $C$) such codes parallel to each other and introduce the lateral coupling factor $\gamma$, by which we take one edge from a graph and couple it with probability $\gamma$ to the top (or bottom) chain at the same time instant. This case is mainly important for the analysis and has a more limited practical implication.

To summarize, one idea presented here is to use several interconnected chains of SC-LDPC codes rather than a single chain. The coding chains could be of different rates, for example when it is known at the transmitter that different parts of the transmitted block will undergo different levels of corruptions, or have the same rate, for example when it is not known which part of the transmitted block will undergo higher corruption rate and which part will confront better channel condition. Each coding chain will then be originally constructed with a higher rate than what is required for the transmission over the worst possible channel condition, namely $R_i$. In order to provide more robustness in the transmission we may also provide a structure to allow different chains provide support to each other through the decoding process by introducing the concept of lateral connectivity. To laterally connect two or more chains of SC-LDPC codes we may share a portion of variable nodes among the chains in each position.

One idea of the inventors is to use several parallel chains of spatially coupled codes and operating them in a multi-level-like coding scenario. However, instead of utilizing several independent codes, it is proposed to employ the novel technique denoted lateral coupling to impose some additional structure on the code and introduce dependencies between the different chains. These dependencies may improve the robustness of the overall coding scheme if, e.g., the different coding chains are connected to transmission channels that have varying error rates or Signal-to-Noise Ratios (SNRs), equivalently. One possible application may be multi-level codes for higher order modulation schemes where the single levels correspond to the bit positions, as shown in Fig. 17. In the case of a specific bit mapping together with laterally coupled codes, each bit level may be mapped to one of the laterally coupled chains. In this case systematic implementation errors can still be recovered, leading to a robust coding scheme. Another possible application is the robust transmission of multimedia data over erasure channels, such as the internet or packet-based transmission links that may undergo packet losses. In this case, the proposed coding structure is more robust against burst losses than previous schemes.

LDPC codes are a large family of efficient error control codes both from the computational point of view as well as the communication rate. However, the low complexity of LDPC codes is due to the use of a suboptimal decoder named Belief-Propagation (BP) decoder, which usually degrades the performance in terms of the achievable transmission rate. In other words there is a gap between the worst channel condition in which one instance of the code can operate reliably (called threshold) under BP decoding compared to the worst channel condition it can handle with a globally optimal Maximum A-Posteriori probability (MAP) decoder.

Among LDPC codes, the family of spatially coupled (SC) LDPC codes is well known for several reasons. An important reason for their fame is that these codes are proved to achieve the (MAP) threshold under the low-complexity BP decoder. In other words, it has been proven that by using the BP decoder, one will not lose any gain in the performance compared to the globally optimal decoder in terms of the threshold of the corresponding uncoupled code ensemble. The BP threshold of the SC code ensemble corresponds to the MAP threshold of the uncoupled LDPC ensemble. Asymptotically, both will be equal, but there is a slight difference in the finite regime. As has been explained, one instance of SC-LDPC codes comprises $L$ copies of a protograph based LDPC code of rate $R$, lifted by a factor $M$ (which could be, in the case of protograph QC codes $P \cdot S$), sequentially placed beside each other, and then sharing edges among the $w$ neighboring copies in each locality, such that variable nodes in position $i$, have check node neighbors in positions ($i-w+1$), ..., $i$. Fig. 24 shows the protograph structure of a SC-LDPC code.

As a result of this structure, the chance of having low degree check nodes 2402 at the end of the chain is very high and hence the BP decoder will be able to recover the values of the variable bits in this part of the chain with high probability. Recovering the variable nodes at the end part of the chain and back-substituting these values in the check equations, is equivalent to removing them from the corresponding graph, which results in decreasing the degrees of the check nodes in the neighboring position and increases the chance of recovering the values of variable nodes in those positions. This phenomenon is similar to a travelling wave of reducing uncertainty which starts at the end part of the chain and travels along the block length. This wave is called the decoding wave.

The merit in the design of SC-LDPC codes is that their decoding is based on a local reduction in the remaining uncertainty of the values of information bits in the transmitted block. This reduction starts at the end of the chain due to the large number of low-degree check nodes at that position and then transfers to the neighboring positions through information propagation over the shared edges. The propagated information reduces the uncertainty in the values of the variable nodes in the neighboring position to enable the decoder to deduce their values based on the noisy information received from the channel along with the information propagated in the fore of the decoding wave. This works perfectly when the amount of the uncertainty is constant over the whole received block which is the case for communication in very large block lengths over ergodic channels which introduce a constant level of corruption to every locality in the transmitted block. However, when the corruption introduced by the channel lacks that stationarity property, the decoding wave will get stuck as soon as it confronts a locality in the block where the amount of corruption is higher than average. This will then affect the decoding of the rest of the block although the corruption might not be that severe on the rest of the block.

An idea presented here is to use several interconnected chains of SC-LDPC codes rather than a single chain. The chains could be of different rates (when it is known at the transmitter that different parts of the transmitted block will undergo different levels of corruptions) or have the same rate (when it is not known which part of the transmitted block will undergo higher corruption rate and which part will confront better channel condition). Each chain will then be originally constructed with a higher rate than what is required for the transmission in the worst possible channel condition, namely $R_j$. In order to provide a higher robustness in the transmission we also provide a structure to allow different chains provide support to each other through the decoding process by introducing the concept of lateral connectivity. To laterally connect two or more chains of SC-LDPC codes we simply share a portion of variable nodes among the chains in each position. **Fig. 25** shows one instance of four laterally connected coding chains in which lateral connectivity is introduced in a non-tail biting sequential manner and where the shared noes can be either assigned to the top or the bottom chain.

However, it is possible to introduce lateral connectivity in various ways following the same principle. One instance of different methods of introducing lateral connectivity is to first choosing the variable nodes to be shared in each position and each chain and then uniformly at random assigning pairs of the selected nodes to each other and replacing them by a single variable node which inherits all the edges of both variable nodes in the selected pair. Another instance could be a tail biting sequential fashion in which selected variable nodes in each position in each chain will be merged only with the selected candidates of the previous and next chains. Given that all the contributing chains are of rate $R_c$, and the probability of sharing variable nodes between different chains is given by $\gamma$, the rate of the overall laterally connected SC-LDPC code may then be given by the following formula:

$$R = \frac{R_c - \dfrac{\gamma}{2}}{1 - \dfrac{\gamma}{2}}.$$

Moreover the density evolution equation of the laterally connected regular SC-LDPC code over the binary erasure channel (BEC) may be given by:

$$x_{c,i}^{(\ell)} = \left( \frac{1}{w} \sum_{j=0}^{w-1} \left( 1 - \left( 1 - \frac{1}{w} \sum_{k=0}^{(w-1)} x_{c,i-j+k}^{(\ell-1)} \right)^{(d_c-1)} \right) \right)^{(d_v-1)} \times$$

$$\left( (1-\gamma)\epsilon_{c,i} + \frac{\gamma}{C} \sum_{z=0, z\neq c}^{C} \left( \frac{\epsilon_{c,i} + \epsilon_{z,i}}{2} \right) \left( \frac{1}{w} \sum_{j=0}^{w-1} \left( 1 - \left( 1 - \frac{1}{w} \sum_{k=0}^{(w-1)} x_{z,i-j+k}^{(\ell-1)} \right)^{(d_c-1)} \right) \right)^{d_v} \right)$$

In the above equation, $x_{c,i}^{(l)}$ represents the probability of erasure of a message in the message passing decoder at position $i$ and in iteration $l$ of chain $c$ in the decoding process. Moreover, $d_c$, $d_v$, $\gamma$, $C$, $\epsilon_{c,i}$ represent check node degree, variable node degree, probability of sharing variable nodes between the chains, number of the chains, and the probability of erasure in the channel corresponding to the variable nodes of position $i$ in chain $c$, respectively.

The concept of lateral connectivity does not significantly affect the complexity of the decoder since the number of edges does not significantly change in the corresponding graph of the code. Moreover in the decoding process of this scheme different chains are active and in each of them there is a decoding wave travelling along the corresponding chain while through the shared variable nodes successful chains will recover a portion of the variable nodes of other chains in which the decoding wave has already got stuck somewhere due to the locally higher than usual corruption. The extra information propagation through the shared vertices then provides the possibility to combat the locally worse channel conditions which occur due to the non-ergodicity in the channel's behavior. The non-ergodicity itself could be caused due to the variation of the channel parameters over time or due to the variance of the empirical distribution of the channel error pattern in finite size realizations at different positions in the transmitted block.

In order to decode the proposed codes, we can employ the windowed decoder introduced in Fig. 2. In this case, the decoder has $C$ (where $C$ is the number of chains) interconnected instances that operate on the equivalent parity check-matrices of the laterally connected code.

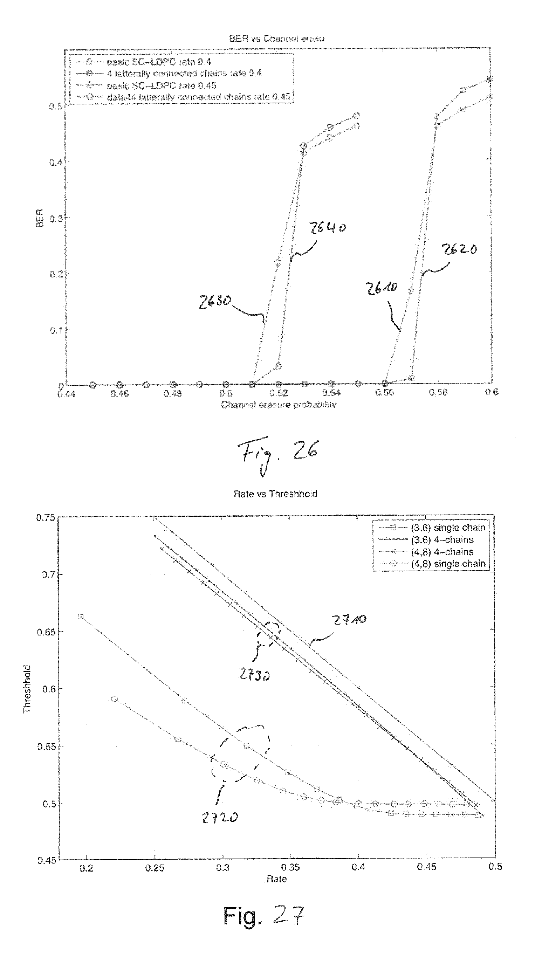

**Fig. 26** shows the performance of an instance of the laterally connected SC-LDPC code over a binary erasure channel (BEC) for two different rates 0.4 and 0.45. Curve 2610 denotes a conventional SC-LDPC code with rate 0.4. Curve 2620 denotes a laterally connected SC-LDPC code with four laterally connected chains at rate 0.4. Curve 2630 denotes a conventional SC-LDPC code with rate 0.45. Curve 2640 denotes a laterally connected SC-LDPC code with four laterally connected chains at rate 0.45. As it may be seen, the new laterally connected code has a slightly better performance in this erasure channel. Note that in this example, in order to have a fair comparison, we selected the lifting factors $M$ such that $M_{LC} = C \cdot M_{SC}$, i.e., the lifting factor of the laterally coupled SC-LDPC code is by a factor $C$ smaller than that of the single-chain code, such that the number of variable nodes in each step of the chain is identical, signifying identical receiver complexity and decoding delay. We can observe that the performance is improved by the proposed scheme.

**Fig. 27** shows the theoretical decoding thresholds versus the rate of different coding realizations. In this figure we compare single chain spatially coupled LDPC codes (see reference numeral 2720) with laterally coupled LDPC codes with $C$=4 (see reference numeral 2730). With conventional terminated SC-LDPC codes, we can realize different code rates and families of codes by selecting the length of the chain $L$ whereas with laterally connected SC-LDPC we have an additional degree of freedom to choose the probability of sharing variable nodes by varying $\gamma$. This additional degree of freedom allows us to finely select codes of different rates such that with a known base codes, new codes of smaller rate can be easily chosen. We can see in Fig. 27 that the expected performance of such codes is close to the theoretically achievable maximum 2710, thus leading to a versatile toolkit for code construction. Note that the markers in Fig. 9 show the possible code realizations. While for the single chain code 2720, the markers represent all possible realizations by varying $L$, only some realizations are shown in the case of the laterally connected codes as by varying the factor $\gamma$, all possible intermediate values are also realizable.

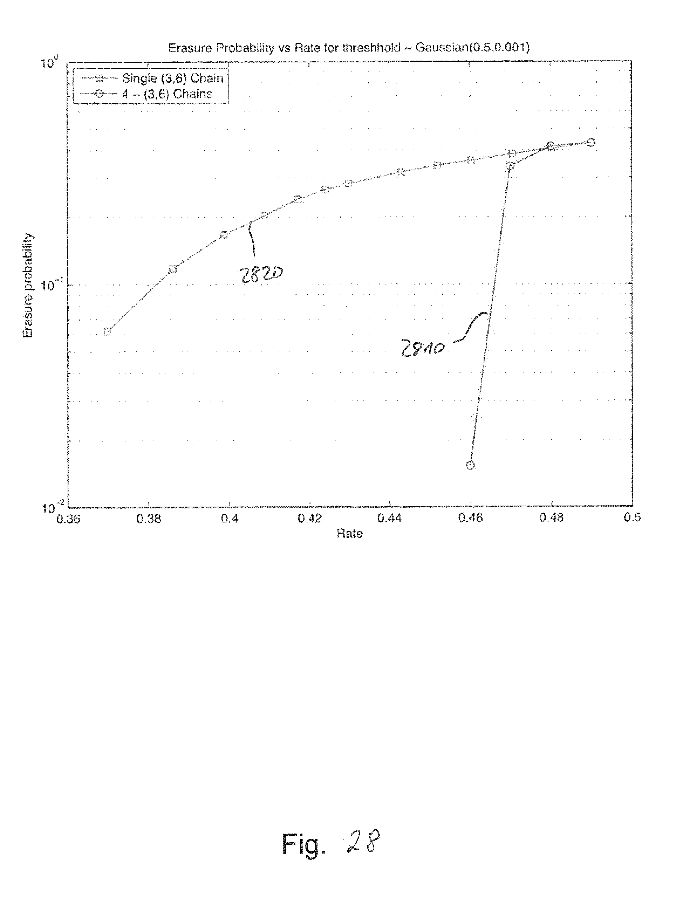

**Fig. 28** shows another advantage of the laterally coupled codes. If the channel has a time-varying parameter, the proposed coding schemes offers higher robustness. In Fig. 28, we employ a binary erasure channel with Gaussian distributed erasure probability (mean 0.5 variance 0.001) The channel quality is varying from one element of the coding chain to the other and kept constant over one step of the chain. We show the density evolution results, i.e., the best possible estimated erasure probability after decoding, for different coding realizations of different rates. We can clearly see that the laterally connected coding scheme (see reference numeral 2810) offers a higher robustness against the varying channel. This can be explained that in the single-chain case (see reference numeral 2820) a small deviation of the channel parameter, i.e., a slightly worse channel at one chain element can stop the decoding wave. By laterally connecting, we allow some seeds from neighboring chains to keep the decoding wave travelling.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "module or entity for s.th." may as well be understood as a "module or entity being adapted or suited for s.th.". A module or entity being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1.   LDPC encoder (1000) for encoding an input signal (1002), comprising:

a first encoder entity (1010) to provide, in accordance with a first LDPC encoding rule, a first encoded output signal (1012) based on the input signal (1002);
a second encoder entity (1020) to provide, in accordance with a second LDPC encoding rule, a second encoded output signal (1022) based on the input signal (1002);
wherein a first bipartite graph (500-1) corresponding to the first LDPC encoding rule is coupled to a second bipartite graph (500-2) corresponding to the second LDPC encoding rule via one or more shared nodes among the first and the second bipartite graph (500-1; 500-2).

2.   The LDPC encoder (1000) of claim 1, wherein the first and the second LDPC encoding rules correspond to convolutional LDPC encoding rules, respectively.

3.   The LDPC encoder (1000) of claim 1, wherein the first bipartite graph (500-1) yields a first coding chain corresponding to a first convolutional LDPC encoding rule and the second bipartite graph (500-2) yields to a second coding chain corresponding to a second convolutional LDPC encoding rule, wherein the first and the second coding chain share at least one variable node and/or at least one check node.

4.   The LDPC encoder (1000) of claim 1, wherein a shared node is assigned to both the first and the second bipartite graph (500-1; 500-2) or wherein a shared node is assigned to either the first or the second bipartite graph (500-1; 500-2).

5.   The LDPC encoder (1000) of claim 1, wherein the first and the second bipartite graph (500-1; 500-2) are coupled at each time instant via at least one variable node and/or at least one check node.

6.   The LDPC encoder (1000) of claim 1, wherein a first coding rate of the first LDPC encoding rule is different from a second coding rate of the second LDPC encoding rule.

7.   The LDPC encoder (1000) of claim 1, wherein the first encoded output signal comprises a first bit of a modulation symbol and the second encoded output signal comprises a second bit of the modulation symbol.

8.   The LDPC encoder (1000) of claim 7, wherein the first and the second encoded output signals are coupled to a mapping module which is operable to map a set of bits comprising the first and the second encoded output signals to the modulation symbol.

9.   The LDPC encoder (1000) of claim 1, wherein the first encoded output signal comprises at least one first parity bit coupled to at least one identical second parity bit of the second encoded output signal, wherein the LDPC encoder (1000) is operable to puncture the first or the second parity bit.

10. The LDPC encoder (1000) of claim 1, wherein the first bipartite graph (500-1) is based on a first protograph and wherein the second bipartite graph (500-2) is based on a second protograph.

11. Method for encoding an input signal (1002), comprising:

   encoding the input signal (1002) in accordance with a first LDPC encoding rule to obtain a first encoded output signal (1012);
   encoding the input signal (1002) in accordance with a second LDPC encoding rule to obtain a second encoded output signal (1022);
   wherein a first bipartite graph (500-1) corresponding to the first LDPC encoding rule is coupled to a second bipartite graph (500-2) corresponding to the second LDPC encoding rule via one or more shared nodes among the first and the second bipartite graph.

12. LDPC decoder (1750; 2100) for decoding an encoded input signal, comprising:

   a first decoder entity (2102) to provide, in accordance with a first LDPC decoding rule, a first decoded output signal based the encoded input signal;
   a second decoder entity (2104) to provide, in accordance with a second LDPC decoding rule, a second decoded output signal based the encoded input signal;
   wherein a first bipartite graph (500-1) corresponding to the first LDPC decoding rule is coupled to a second bipartite graph (500-2) corresponding to the second LDPC decoding rule via one or more shared nodes among the first and the second bipartite graph.

13. The LDPC decoder (1750; 2100) of claim 12, wherein the first and the second LDPC decoding rules are based on first and second spatially coupled LDPC encoding rules, respectively.

14. The LDPC decoder (1750; 2100) of claim 12, comprising an a-posteriori memory (2122) shared by the first and the second decoder entity (2102; 2104), wherein the shared a-posteriori memory (2122) corresponds to the nodes shared among the first and the second bipartite graph.

15. Method for decoding an encoded input signal, comprising:

   decoding the encoded input signal in accordance with a first LDPC decoding rule to obtain a first decoded output signal;
   decoding the encoded input signal in accordance with a second LDPC decoding rule to obtain a second decoded output signal;
   wherein a first bipartite graph corresponding to the first LDPC decoding rule is coupled to a second bipartite graph corresponding to the second LDPC decoding rule via one or more shared nodes among the first and the second bipartite graph.

Fig. 1

Fig. 2

Fig. 3

Fig. 4

EP 2 890 016 A1

$$\mathbf{B} = \begin{pmatrix} 2 & 1 & & & & & & & \\ 2 & 3 & 2 & 1 & & & & & \\ & & 2 & 3 & 2 & 1 & & & \\ & & & & 2 & 3 & 2 & 1 & \\ & & & & & & 2 & 3 & 2 & 1 \\ & & & & & & & \ddots & \ddots & \ddots & \ddots \end{pmatrix}$$

Fig. 5

28

Fig. 6

Fig. 7

Fig. 8

900

910

Code $C$ → Π → Mapping $\varphi$ → $X$ → Channel → $Y$ → Demapper $\varphi^{-1}$ → Π$^{-1}$ → Decoder $D$

Π

902    904    906

912

914

904

916

Fig. 9

*1000*

*1010*

$\mathbf{x}_{1,t} = (x_{1,t,1}, \ldots, x_{1,t,K})^{\mathrm{T}}$   $\mathbf{y}_{1,t} = (y_{1,t,1}, \ldots, y_{1,t,N})^{\mathrm{T}}$

*1012*

T

*1014*

$\mathbf{y}_{1,t-1} = (y_{1,t-1,1}, \ldots, y_{1,t-1,N})^{\mathrm{T}}$

*1020*

*1002*

$\mathbf{x}_{2,t} = (x_{2,t,1}, \ldots, x_{2,t,K})^{\mathrm{T}}$   $\mathbf{y}_{2,t} = (y_{2,t,1}, \ldots, y_{2,t,N})^{\mathrm{T}}$

*1022*

T

*1024*

$\mathbf{y}_{2,t-1} = (y_{2,t-1,1}, \ldots, y_{2,t-1,N})^{\mathrm{T}}$

Fig. 10

*1100*

*1110*

$\mathbf{x}_{1,t} = (x_{1,t,1}, \ldots, x_{1,t,K})^{\mathrm{T}}$   $\mathbf{y}_{1,t} = (y_{1,t,1}, \ldots, y_{1,t,N})^{\mathrm{T}}$

T

$\mathbf{y}_{1,t-1} = (y_{1,t-1,1}, \ldots, y_{1,t-1,N})^{\mathrm{T}}$

*1120*

$\mathbf{x}_{2,t} = (x_{2,t,1}, \ldots, x_{2,t,K})^{\mathrm{T}}$   $\mathbf{y}_{2,t} = (y_{2,t,1}, \ldots, y_{2,t,N})^{\mathrm{T}}$

T

$\mathbf{y}_{2,t-1} = (y_{2,t-1,1}, \ldots, y_{2,t-1,N})^{\mathrm{T}}$

Fig. 11

500-1

Chain 1

1204-1   1204-1   1204-1   1204-1   1204-1

1202   1202   1202   1202   1202

1204-2   1204-2   1204-2   1204-2   1204-2

Chain 2

500-2

Fig. 12

Chain 1

$$
\mathbf{B}_L =
\begin{matrix}
2 & 1 \\
2 & 3 & 2 & 1 \\
 & & 2 & 3 & 2 & 1 \\
 & & & & 2 & 3 & 2 & 1 \\
 & & & & & & 2 & 3 & 2 & 1 \\
\end{matrix}
$$

Chain 2

$$
\begin{matrix}
2 & 1 \\
2 & 3 & 2 & 1 \\
 & & 2 & 3 & 2 & 1 \\
 & & & & 2 & 3 & 2 & 1 \\
 & & & & & & 2 & 3 & 2 & 1 \\
\end{matrix}
$$

Lateral Coupling

$$
\begin{matrix}
1 & & & & & & 1 \\
 & 1 & & & & & & 1 \\
 & & 1 & & & & & & 1 \\
 & & & 1 & & & & & & 1 \\
\end{matrix}
$$

Fig. 13

Fig. 14

Chain 1 with shared nodes

Fig. 15

Fig. 16

Fig. 17

1800-1

1800-2

Fig. 18

1900-1

1900-2

Fig. 19

aposteriori
memory of
chain 1

Windowed Decoder Chain 1

Windowed Decoder Chain 2

Windowed Decoder Chain 3

Fig. 20

Fig. 21

Fig. 22

Fig. 23

Fig. 24

Fig. 25

BER vs Channel erasu

Fig. 26

Rate vs Threshhold

Fig. 27

Fig. 28

Europäisches
Patentamt

European
Patent Office

Office européen
des brevets

# EUROPEAN SEARCH REPORT

Application Number

EP 13 30 6892

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/139025 A1 (GIOULEKAS FOTIOS [GR] ET AL) 30 May 2013 (2013-05-30) <br> * abstract; figures 2-8, 10, 15, 20, 21 * <br> * paragraphs [0006], [0049] - [0094], [0116] - paragraph [0145] * <br> ----- | 1-15 | INV. <br> H03M13/11 <br> H03M13/29 <br> H03M13/00 |
| X | OLMOS PABLO M ET AL: "A finite length performance analysis of LDPC codes constructed by connecting spatially coupled chains", <br> 2013 IEEE INFORMATION THEORY WORKSHOP (ITW), IEEE, <br> 9 September 2013 (2013-09-09), pages 1-5, XP032536270, <br> DOI: 10.1109/ITW.2013.6691239 <br> ISBN: 978-1-4799-1321-3 <br> [retrieved on 2013-12-20] <br> * abstract * <br> * paragraphs [000I] - [0III], [000V] * <br> & DMITRI TRUHACHEV ET AL: "Improving spatially coupled LDPC codes by connecting chains", <br> INFORMATION THEORY PROCEEDINGS (ISIT), 2012 IEEE INTERNATIONAL SYMPOSIUM ON, IEEE, <br> 1 July 2012 (2012-07-01), pages 468-472, XP032225922, <br> DOI: 10.1109/ISIT.2012.6284232 <br> ISBN: 978-1-4673-2580-6 <br> * the whole document * <br> ----- | 1-15 | |
| X <br> A | US 2013/086456 A1 (YEDIDIA JONATHAN [US] ET AL) 4 April 2013 (2013-04-04) <br> * paragraph [0034] - paragraph [0137]; figures 5a, 5b * <br> ----- <br> -/-- | 1,11,12, 15 <br> 2-10,13, 14 | TECHNICAL FIELDS SEARCHED (IPC) <br><br> H03M |

The present search report has been drawn up for all claims

| Place of search | Date of completion of the search | Examiner |
|---|---|---|
| The Hague | 8 April 2014 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt European Patent Office Office européen des brevets | **EUROPEAN SEARCH REPORT** | Application Number EP 13 30 6892 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 204 911 A1 (PANASONIC CORP [JP]) 7 July 2010 (2010-07-07) * the whole document * ----- | 7,8 | |
| A | US 2008/109708 A1 (KIM DONG-HO [KR] ET AL) 8 May 2008 (2008-05-08) * abstract * ----- | 1-15 | |
| A | US 2011/307756 A1 (DIVSALAR D; NGUYEN T V; NOSRATINIA A) 15 December 2011 (2011-12-15) * paragraph [0013] - paragraph [0022]; figures 2,14, 15 * ----- | 1-15 | |
| A | EP 2 525 496 A1 (PANASONIC CORP [JP]) 21 November 2012 (2012-11-21) * the whole document * ----- | 7,8 | |

TECHNICAL FIELDS
SEARCHED      (IPC)

The present search report has been drawn up for all claims

| Place of search | Date of completion of the search | Examiner |
|---|---|---|
| The Hague | 8 April 2014 | Belardinelli, Carlo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 13 30 6892

This annex lists the patent family members relating to the patent documents cited in the above-mentioned European search report.
The members are as contained in the European Patent Office EDP file on
The European Patent Office is in no way liable for these particulars which are merely given for the purpose of information.

08-04-2014

| Patent document cited in search report | | Publication date | Patent family member(s) | | Publication date |
|---|---|---|---|---|---|
| US 2013139025 | A1 | 30-05-2013 | NONE | | |
| US 2013086456 | A1 | 04-04-2013 | JP | 2013081161 A | 02-05-2013 |
| | | | US | 2013086456 A1 | 04-04-2013 |
| EP 2204911 | A1 | 07-07-2010 | CN | 101842992 A | 22-09-2010 |
| | | | EP | 2204911 A1 | 07-07-2010 |
| | | | JP | 5247355 B2 | 24-07-2013 |
| | | | JP | 2009135911 A | 18-06-2009 |
| | | | US | 2010251061 A1 | 30-09-2010 |
| US 2008109708 | A1 | 08-05-2008 | KR | 20080041054 A | 09-05-2008 |
| | | | US | 2008109708 A1 | 08-05-2008 |
| US 2011307756 | A1 | 15-12-2011 | US | 2011307756 A1 | 15-12-2011 |
| | | | WO | 2012039798 A2 | 29-03-2012 |
| EP 2525496 | A1 | 21-11-2012 | CN | 103636131 A | 12-03-2014 |
| | | | EP | 2525496 A1 | 21-11-2012 |
| | | | EP | 2566054 A1 | 06-03-2013 |
| | | | TW | 201315161 A | 01-04-2013 |
| | | | WO | 2012157286 A1 | 22-11-2012 |

EPO FORM P0459

For more details about this annex : see Official Journal of the European Patent Office, No. 12/82